# EUROPEAN PATENT APPLICATION

(11) **EP 4 369 610 A1**
(43) Date of publication of application: **15.05.2024**
(21) Application number: 22847928.3
(22) Date of filing: 05.05.2022
(51) Int. Cl.: H03M 13/00, H04L 1/00

(54) **LINK MONITORING METHOD AND DEVICE**

(30) Priority: 26.07.2021 CN 202110846541
(71) Applicant: Huawei Technologies Co., Ltd., Shenzhen, Guangdong 518129 (CN)
(72) Inventor: HUANG, Kechao, Shenzhen, Guangdong 518129 (CN); LEUNG, Wai Kong Raymond, Shenzhen, Guangdong 518129 (CN); MA, Huixiao, Shenzhen, Guangdong 518129 (CN); YANG, Xiaoling, Shenzhen, Guangdong 518129 (CN)
(74) Representative: Gill Jennings & Every LLP
(86) International application number: PCT/CN2022/090977
(87) International publication number: WO 2023/005313

(57) **Abstract**

This application discloses a link monitoring method and apparatus, and belongs to the field of data transmission technologies. The method includes: receiving outer-code encoded data; performing inner-code encoding on the outer-code encoded data, and outputting inner-code encoded data; performing outer-code decoding on the outer-code encoded data; and determining, based on a status of performing outer-code decoding on the outer-code encoded data, quality of a link for transmission of the outer-code encoded data. This application can effectively monitor the quality of the link.

## Description

This application claims priority to Chinese Patent Application No. 202110846541.6, filed on July 26, 2021 and entitled "LINK MONITORING METHOD AND APPARATUS", which is incorporated herein by reference in its entirety.

### TECHNICAL FIELD

This application relates to the field of data transmission technologies, and in particular, to a link monitoring method and apparatus.

### BACKGROUND

Continuously driven by 5G, cloud computing, big data, and artificial intelligence, an optical communication system and an optical transport network (optical transport network, OTN) are developing towards the trend of large capacity and an ultra-high speed. Optical signals transmitted in the optical communication system and the optical transport network may be distorted due to some reasons in a transmission process, and a transmission bit error rate of the optical signal increases with an increase of an Ethernet transmission rate. Forward error correction (forward error correction, FEC) encoding is used to correct transmitted data, to resolve the problem of transmission bit error, and restore raw data from received data sent by a transmitter. In addition, FEC decoding may further assist in link monitoring. Link monitoring means monitoring quality of a link for data transmission.

However, there is no effective method for monitoring quality of a link currently.

### SUMMARY

This application provides a link monitoring method and apparatus, to effectively monitor quality of a link. The technical solutions provided in this application are as follows:

According to a first aspect, this application provides a link monitoring method. The method includes: receiving outer-code encoded data; performing inner-code encoding on the outer-code encoded data, and outputting inner-code encoded data; performing outer-code decoding on the outer-code encoded data; and determining, based on a status of performing outer-code decoding on the outer-code encoded data, quality of a link for transmission of the outer-code encoded data.

In the link monitoring method, the outer-code encoded data is received, inner-code encoding is performed on the outer-code encoded data, and the inner-code encoded data is output. In addition, outer-code decoding is performed on the outer-code encoded data, and the quality of the link for transmission of the outer-code encoded data is determined based on the status of performing outer-code decoding on the outer-code encoded data. This effectively monitors the quality of the link.

In addition, in the link monitoring method, inner-code encoding needs to be performed on the outer-code encoded data, and the inner-code encoded data is output. In addition, outer-code decoding is performed on the outer-code encoded data, and the quality of the link is determined based on the status of the outer-code decoding. The two processes are separately performed. Therefore, the process of performing outer-code decoding on the data and determining the quality of the link does not affect the process of performing inner-code encoding on the data and outputting the inner-code encoded data, and does not additionally increase an overall transmission delay of data. Therefore, the link monitoring method can be applied to more transmission scenarios, and in particular, to a transmission scenario that has a low requirement on a transmission delay.

In an implementation, because a quantity of erroneous symbols in a codeword sequence can reflect impact of the codeword sequence on the link, a transmitter processing module may determine the quality of the link based on the quantity of erroneous symbols in the codeword sequence. Then, the determining, based on a status of performing outer-code decoding on the outer-code encoded data, quality of a link for transmission of the outer-code encoded data includes: determining a quantity of erroneous symbols in each of P1 codeword sequences based on a status of performing outer-code decoding on the P1 codeword sequences of the outer-code encoded data, where P1 is a positive integer; and determining the quality of the link based on a quantity of erroneous symbols in the P1 codeword sequences.

The transmitter processing module may determine, based on a quantity of erroneous symbols in one or more (namely, P1) codeword sequences of the outer-code encoded data, the quality of the link for transmission of the outer-code encoded data. In this case, the transmitter processing module needs to separately determine the quantity of erroneous symbols in each of the P1 codeword sequences. In addition, when the quality of the link is determined based on the quantity of erroneous symbols in the plurality of codeword sequences of the outer-code encoded data, because the quantity of erroneous symbols in the plurality of codeword sequences can more comprehensively reflect impact of the codeword sequences on the link, the quality of the link can be monitored more accurately.

In another implementation, the determining, based on a status of performing outer-code decoding on the outer-code encoded data, quality of a link for transmission of the outer-code encoded data includes: determining, based on a status of performing outer-code decoding on a codeword sequence of the outer-code encoded data, an indication parameter corresponding to the codeword sequence; and determining the quality of the link based on indication parameters corresponding to P2 codeword sequences of the outer-code encoded data, where P2 is a positive integer.

When the quality of the link is determined based on the quantity of erroneous symbols in the plurality of codeword sequences of the outer-code encoded data, because the quantity of erroneous symbols in the plurality of codeword sequences can more comprehensively reflect impact of the codeword sequences on the link, the quality of the link can be monitored more accurately.

Optionally, specific implementations of outer-code decoded data vary with different application scenarios. The following cases are used as examples for description.

In a case, the outer-code decoded data is data on which outer-code encoding and de-skewing are performed. For example, after receiving the outer-code encoded data, the transmitter processing module may first perform de-skewing on the outer-code encoded data, and then perform outer-code decoding on de-skewed data. De-skewing is first performed on the outer-code encoded data, outer-code decoding is performed on the de-skewed data, and then the quality of the link for transmission of the outer-code encoded data is determined based on the status of the outer-code decoding. Because data for determining the quality of the link is de-skewed data, accuracy of the quality of the link determined based on the data can be effectively ensured.

In another case, the outer-code decoded data is data on which outer-code encoding, lane reordering, and first de-interleaving are performed. For example, after receiving the outer-code encoded data, the transmitter processing module may first perform de-skewing and lane reordering on the outer-code encoded data, perform first de-interleaving on lane-reordered data, and then perform outer-code decoding on data on which first de-interleaving is performed.

In still another case, the outer-code decoded data is data on which outer-code encoding and data extraction are performed. For example, after receiving the outer-code encoded data, the transmitter processing module may first perform data extraction on the outer-code encoded data, and then perform outer-code decoding on data-extracted data. When a data amount of the data after data extraction is less than a data amount of the data before data extraction, a rate of the data obtained through data extraction can be less than a rate of the data inner-code encoded by the transmitter processing module. This can reduce a rate of a de-skewed data, and implement monitoring with low power consumption.

Optionally, specific implementations of the inner-code encoded data vary with different application scenarios. The following cases are used as examples for description.

In a case, the inner-code encoded data is data on which outer-code encoding is performed. For example, after receiving the outer-code encoded data, the transmitter processing module may directly perform inner-code encoding on the outer-code encoded data.

In another case, the inner-code encoded data is data on which outer-code encoding and de-skewing are performed. When the inner-code encoded data is the data on which outer-code encoding and de-skewing are performed, and the outer-code decoded data is the data on which outer-code encoding and de-skewing are performed, de-skewing may be performed after the transmitter processing module receives the outer-code encoded data. After de-skewing is performed, two types of processing may be performed on de-skewed data. One type of processing is that the transmitter processing module performs inner-code encoding and outputs data, and the other type of processing is that the transmitter processing module performs outer-code decoding.

In yet another case, the inner-code encoded data is data on which outer-code encoding, de-skewing, and lane reordering are performed. In this way, regardless of a sequence of a plurality of lanes of data obtained by the transmitter processing module, lane reordering is performed on the data, and then inner-code encoding is performed on lane-reordered data, so that the inner-code encoded data that is output by the transmitter processing module is ordered based on a sequence specified in lane reordering. Therefore, when a performance test is performed on the transmitter processing module, different transmitter processing modules of a same type have same output data when input data is the same. This facilitates the performance test of the transmitter processing module. In addition, if first interleaving further needs to be performed on the data before inner-code encoding is performed on the data, because all data on which lane reordering is to be performed can be ordered based on the sequence specified in lane reordering, a sequence of the data on which first interleaving is performed is fixed. This facilitates design of a first interleaving processing unit.

In still another case, the inner-code encoded data is data on which outer-code encoding, de-skewing, lane reordering, and first de-interleaving are performed. In addition, two types of processing may be performed on the data on which de-skewing, lane reordering, and first de-interleaving are performed. One type of processing is inner-code encoding, and the other type of processing is outer-code decoding.

In yet another case, the inner-code encoded data is data on which outer-code encoding and data processing are performed, and the data processing includes first interleaving. For example, after receiving the outer-code encoded data, the transmitter processing module may first perform de-skewing on the outer-code encoded data, perform first interleaving on de-skewed data, and then perform inner-code encoding on data on which first interleaving is performed. For another example, after receiving the outer-code encoded data, on one hand, the transmitter processing module may perform de-skewing on the outer-code encoded data. On the other hand, the transmitter processing module may perform first interleaving on the outer-code encoded data, and then perform inner-code encoding on data on which first interleaving is performed.

According to a second aspect, this application provides a link monitoring method. The method includes: receiving outer-code encoded and inner-code encoded data; performing inner-code decoding on the outer-code encoded and inner-code encoded data, and outputting inner-code decoded data; performing outer-code decoding on the inner-code decoded data; and determining, based on a status of performing outer-code decoding on the inner-code decoded data, quality of a link for transmission of the outer-code encoded and inner-code encoded data.

In the link monitoring method, the outer-code encoded and inner-code encoded data is received, inner-code decoding is performed on the outer-code encoded and inner-code encoded data, and the inner-code decoded data is output. In addition, outer-code decoding is performed on the inner-code decoded data, and the quality of the link for transmission of the outer-code encoded and inner-code encoded data is determined based on the status of performing outer-code decoding on the inner-code decoded data. This can effectively monitor the quality of the link.

In addition, in the link monitoring method, the inner-code decoded data needs to be output. In addition, outer-code decoding also needs to be performed on the inner-code decoded data, and the quality of the link is determined based on the status of the outer-code decoding. The two processes are separately performed. Therefore, the process of performing outer-code decoding on the data and determining the quality of the link does not affect the process of outputting the inner-code decoded data, and does not additionally increase an overall transmission delay of data. Therefore, the link monitoring method can be applied to more transmission scenarios, and in particular, to a transmission scenario that has a low requirement on a transmission delay.

In an implementation, because a quantity of erroneous symbols in a codeword sequence can reflect impact of the codeword sequence on the link, a receiver processing module may determine the quality of the link based on the quantity of erroneous symbols in the codeword sequence. Then, the determining, based on a status of performing outer-code decoding on the inner-code decoded data, quality of a link for transmission of the outer-code encoded and inner-code encoded data includes: determining a quantity of erroneous symbols in each of P3 codeword sequences based on a status of performing outer-code decoding on the P3 codeword sequences of the inner-code decoded data, where P3 is a positive integer; and determining the quality of the link based on a quantity of erroneous symbols in the P3 codeword sequences.

The receiver processing module may determine, based on a quantity of erroneous symbols in one or more (namely, P3) codeword sequences of the inner-code decoded data, the quality of the link for transmission of the outer-code encoded and inner-code encoded data. In this case, the receiver processing module needs to separately determine the quantity of erroneous symbols in each of the P3 codeword sequences. In addition, when the quality of the link is determined based on the quantity of erroneous symbols in the plurality of codeword sequences of the inner-code decoded data, because the quantity of erroneous symbols in the plurality of codeword sequences can more comprehensively reflect impact of the codeword sequences on the link, the quality of the link can be monitored more accurately.

In another implementation, the determining, based on a status of performing outer-code decoding on the inner-code decoded data, quality of a link for transmission of the outer-code encoded and inner-code encoded data includes: determining, based on a status of performing outer-code decoding on the codeword sequence of the inner-code decoded data, an indication parameter corresponding to a codeword sequence; and determining the quality of the link based on indication parameters corresponding to P4 codeword sequences of the inner-code decoded data, where P4 is a positive integer.

When the quality of the link is determined based on the quantity of erroneous symbols in the plurality of codeword sequences of the inner-code decoded data, because the quantity of erroneous symbols in the plurality of codeword sequences can more comprehensively reflect impact of the codeword sequences on the link, the quality of the link can be monitored more accurately.

Optionally, specific implementations of outer-code decoded data vary with different application scenarios. The following cases are used as examples for description.

In a case, the outer-code decoded data is data on which inner-code decoding and de-skewing are performed. For example, after receiving the inner-code decoded data, the receiver processing module may first perform de-skewing on the inner-code decoded data, and then perform outer-code decoding on de-skewed data.

In another case, the outer-code decoded data is data on which inner-code decoding, lane reordering, and first de-interleaving are performed. For example, after receiving the inner-code decoded data, the receiver processing module may first perform lane reordering on the inner-code decoded data, perform first de-interleaving on lane-reordered data, and then perform outer-code decoding on data on which first de-interleaving is performed.

In yet another case, when the outer-code encoded and inner-code encoded data is lane-reordered data, the outer-code decoded data is data on which inner-code decoding and first de-interleaving are performed.

In still another case, the outer-code decoded data is data on which inner-code decoding and data extraction are performed. For example, after receiving the inner-code decoded data, the receiver processing module may first perform data extraction on the inner-code decoded data, and then perform outer-code decoding on data-extracted data. When a data amount of the data after data extraction is less than a data amount of the data before data extraction, a rate of the data obtained through data extraction can be less than a rate of the data inner-code encoded by the transmitter processing module. This can reduce a rate of a de-skewed data, and implement monitoring with low power consumption.

In yet another case, the inner-code decoded data is data on which data processing is performed, the outer-code decoded data is data on which inner-code decoding and inverse processing of the data processing are performed, the data processing includes first interleaving, and the inverse processing includes second de-interleaving. For example, after receiving the inner-code decoded data, the receiver processing module may first perform second de-interleaving on the inner-code decoded data, and then perform outer-code decoding on data on which second de-interleaving is performed. In addition, when the data output by the receiver processing module is the data on which inner-code decoding and inverse processing of the data processing are performed, and the outer-code decoded data is the data on which inner-code decoding and inverse processing of the data processing are performed, the inverse processing may be performed after the receiver processing module receives the inner-code decoded data. After the inverse processing is performed, two types of processing may be performed on data on which inverse processing is performed. One type of processing is that the receiver processing module outputs the data, and the other type of processing is that the receiver processing module performs outer-code decoding. In this way, a process of performing outer-code decoding on the data and detecting the quality of the link does not affect a process of outputting the data by the receiver processing module, and does not additionally increase a transmission delay of data, to effectively reduce an overall transmission delay of the data.

Optionally, specific implementations of the output data vary with different application scenarios. The following cases are used as examples for description.

In a case, the output data is data on which inner-code decoding is performed. For example, after performing inner-code decoding on the outer-code encoded and inner-code encoded data, the receiver processing module may directly output the inner-code decoded data.

In still another case, the inner-code decoded data is data on which data processing is performed, the output data is data on which inner-code decoding and inverse processing of the data processing are performed, the data processing includes first interleaving, and the inverse processing includes second de-interleaving. For example, after receiving the outer-code encoded and inner-code encoded data, the receiver processing module may first perform inner-code decoding on the outer-code encoded and inner-code encoded data, perform second de-interleaving on inner-code decoded data, and then output data on which second de-interleaving is performed.

According to a third aspect, this application provides a link monitoring apparatus. The apparatus includes: an input unit, configured to receive outer-code encoded data; an encoding unit, configured to perform inner-code encoding on the outer-code encoded data; an output unit, configured to output inner-code encoded data; and a decoding unit, configured to perform outer-code decoding on the outer-code encoded data. The decoding unit is further configured to determine, based on a status of performing outer-code decoding on the outer-code encoded data, quality of a link for transmission of the outer-code encoded data.

Optionally, the decoding unit is specifically configured to: determine a quantity of erroneous symbols in each of P1 codeword sequences based on a status of performing outer-code decoding on the P1 codeword sequences of the outer-code encoded data, where P1 is a positive integer; and determine the quality of the link based on a quantity of erroneous symbols in the P1 codeword sequences.

Optionally, the decoding unit is specifically configured to: determine, based on a status of performing outer-code decoding on a codeword sequence of the outer-code encoded data, an indication parameter corresponding to the codeword sequence; and determine the quality of the link based on indication parameters corresponding to P2 codeword sequences of the outer-code encoded data, where P2 is a positive integer.

Optionally, outer-code decoded data is data on which outer-code encoding and de-skewing are performed.

Optionally, the outer-code decoded data is data on which outer-code encoding, lane reordering, and first de-interleaving are performed.

Optionally, the outer-code decoded data is data on which outer-code encoding and data extraction are performed.

Optionally, the inner-code encoded data is data on which outer-code encoding is performed.

Optionally, the inner-code encoded data is data on which outer-code encoding and de-skewing are performed.

Optionally, the inner-code encoded data is data on which outer-code encoding, de-skewing, and lane reordering are performed.

Optionally, the inner-code encoded data is data on which outer-code encoding, de-skewing, lane reordering, and first de-interleaving are performed.

Optionally, the inner-code encoded data is data on which outer-code encoding and data processing are performed, and the data processing includes first interleaving.

According to a fourth aspect, this application provides a link monitoring apparatus. The apparatus includes: an input unit, configured to receive outer-code encoded and inner-code encoded data; a first decoding unit, configured to perform inner-code decoding on the outer-code encoded and inner-code encoded data; an output unit, configured to output inner-code decoded data; and a second decoding unit, configured to perform outer-code decoding on the inner-code decoded data. The second decoding unit is further configured to determine, based on a status of performing outer-code decoding on the inner-code decoded data, quality of a link for transmission of the outer-code encoded and inner-code encoded data.

Optionally, the second decoding unit is specifically configured to: determine a quantity of erroneous symbols in each of P3 codeword sequences based on a status of performing outer-code decoding on the P3 codeword sequences of the inner-code decoded data, where P3 is a positive integer; and determine the quality of the link based on a quantity of erroneous symbols in the P3 codeword sequences.

Optionally, the second decoding unit is specifically configured to: determine, based on a status of performing outer-code decoding on the codeword sequence of the inner-code decoded data, an indication parameter corresponding to a codeword sequence; and determine the quality of the link based on indication parameters corresponding to P4 codeword sequences of the inner-code decoded data, where P4 is a positive integer.

Optionally, outer-code decoded data is data on which inner-code decoding and de-skewing are performed.

Optionally, the outer-code decoded data is data on which inner-code decoding and first de-interleaving are performed.

Optionally, the outer-code decoded data is data on which inner-code decoding, lane reordering, and first de-interleaving are performed.

Optionally, the outer-code decoded data is data on which inner-code decoding and data extraction are performed.

Optionally, the inner-code decoded data is data on which data processing is performed, the outer-code decoded data is data on which inner-code decoding and inverse processing of the data processing are performed, the data processing includes first interleaving, and the inverse processing includes second de-interleaving.

Optionally, the output data is inner-code decoded data.

Optionally, the inner-code decoded data is the data on which data processing is performed, the output data is data on which inner-code decoding and inverse processing of the data processing are performed, the data processing includes first interleaving, and the inverse processing includes second de-interleaving.

According to a fifth aspect, this application provides a computer device, including a memory and a processor. The memory stores program instructions, and the processor runs the program instructions, to perform the method in the first aspect, the second aspect, and any one of the possible implementations of the first aspect and the second aspect of this application.

According to a sixth aspect, this application provides a computer-readable storage medium. The computer-readable storage medium is a non-volatile computer-readable storage medium, and includes program instructions. When the program instructions are run on a computer device, the computer device is enabled to perform the method in the first aspect, the second aspect, and any one of the possible implementations of the first aspect and the second aspect of this application.

According to a seventh aspect, this application provides a computer program product including instructions. When the computer program product runs on a computer, the computer is enabled to perform the method in the first aspect, the second aspect, and any one of the possible implementations of the first aspect and the second aspect of this application.

### BRIEF DESCRIPTION OF DRAWINGS

FIG. 1 is a schematic diagram of an implementation environment related to a link monitoring method according to an embodiment of this application;
FIG. 2 is a schematic flowchart of a data transmission process in the implementation environment shown in FIG. 1 according to an embodiment of this application;
FIG. 3 is a flowchart of a link monitoring method applied to a transmitter processing module according to an embodiment of this application;
FIG. 4 is a schematic diagram of a structure of a transmitter processing module according to an embodiment of this application;
FIG. 5 is a schematic diagram of a structure of another transmitter processing module according to an embodiment of this application;
FIG. 6 is a schematic diagram of a structure of still another transmitter processing module according to an embodiment of this application;
FIG. 7 is a schematic diagram of a structure of yet another transmitter processing module according to an embodiment of this application;
FIG. 8 is a schematic diagram of a structure of still another transmitter processing module according to an embodiment of this application;
FIG. 9 is a schematic diagram of a structure of yet another transmitter processing module according to an embodiment of this application;
FIG. 10 is a schematic diagram of a structure of still another transmitter processing module according to an embodiment of this application;
FIG. 11 is a schematic diagram of a structure of yet another transmitter processing module according to an embodiment of this application;
FIG. 12 is a schematic diagram of a structure of still another transmitter processing module according to an embodiment of this application;
FIG. 13 is a schematic diagram of a structure of yet another transmitter processing module according to an embodiment of this application;
FIG. 14 is a schematic diagram of a structure of still another transmitter processing module according to an embodiment of this application;
FIG. 15 is a schematic diagram of a structure of yet another transmitter processing module according to an embodiment of this application;
FIG. 16 is a schematic diagram of data extraction according to an embodiment of this application;
FIG. 17 is a flowchart of a method in which a transmitter processing module determines quality of a link based on a status of outer-code decoding according to an embodiment of this application;
FIG. 18 is a flowchart of another method in which a transmitter processing module determines quality of a link based on a status of outer-code decoding according to an embodiment of this application;
FIG. 19 is a flowchart of a link monitoring method applied to a receiver processing module according to an embodiment of this application;
FIG. 20 is a schematic diagram of a structure of a receiver processing module according to an embodiment of this application;
FIG. 21 is a schematic diagram of a structure of another receiver processing module according to an embodiment of this application;
FIG. 22 is a schematic diagram of a structure of still another receiver processing module according to an embodiment of this application;
FIG. 23 is a schematic diagram of a structure of yet another receiver processing module according to an embodiment of this application;
FIG. 24 is a schematic diagram of a structure of still another receiver processing module according to an embodiment of this application;
FIG. 25 is a schematic diagram of a structure of yet another receiver processing module according to an embodiment of this application;
FIG. 26 is a schematic diagram of a structure of still another receiver processing module according to an embodiment of this application;
FIG. 27 is a schematic diagram of a structure of yet another receiver processing module according to an embodiment of this application;
FIG. 28 is a schematic diagram of a structure of still another receiver processing module according to an embodiment of this application;
FIG. 29 is a schematic diagram of a structure of yet another receiver processing module according to an embodiment of this application;
FIG. 30 is a schematic diagram of a structure of still another receiver processing module according to an embodiment of this application;
FIG. 31 is a schematic diagram of a structure of yet another receiver processing module according to an embodiment of this application;
FIG. 32 is a schematic diagram of a structure of still another receiver processing module according to an embodiment of this application;
FIG. 33 is a flowchart of a method in which a receiver processing module determines quality of a link based on a status of outer-code decoding according to an embodiment of this application;
FIG. 34 is a flowchart of another method in which a receiver processing module determines quality of a link based on a status of outer-code decoding according to an embodiment of this application;
FIG. 35 is a flowchart of another link monitoring method applied to a transmitter processing module according to an embodiment of this application;
FIG. 36 is a flowchart of still another link monitoring method applied to a receiver processing module according to an embodiment of this application;
FIG. 37 is a schematic diagram of an application scenario in which a link monitoring method is applicable to a transmitter optical module with a coherent line interface of an 800 G single-wavelength and a transmitter device with a 2*400 G interface according to an embodiment of this application;
FIG. 38 is another schematic diagram of an application scenario in which a link monitoring method is applicable to a transmitter optical module with a coherent line interface of an 800 G single-wavelength and a transmitter device with a 2*400 G interface according to an embodiment of this application;
FIG. 39 is still another schematic diagram of an application scenario in which a link monitoring method is applicable to a transmitter optical module with a coherent line interface of an 800 G single-wavelength and a transmitter device with a 2*400 G interface according to an embodiment of this application;
FIG. 40 is a schematic diagram of an application scenario in which a link monitoring method is applicable to a receiver optical module with a coherent line interface of an 800 G single-wavelength and a receiver device with a 2*400 G interface according to an embodiment of this application;
FIG. 41 is another schematic diagram of an application scenario in which a link monitoring method is applicable to a receiver optical module with a coherent line interface of an 800 G single-wavelength and a receiver device with a 2*400 G interface according to an embodiment of this application;
FIG. 42 is still another schematic diagram of an application scenario in which a link monitoring method is applicable to a receiver optical module with a coherent line interface of an 800 G single-wavelength and a receiver device with a 2*400 G interface according to an embodiment of this application;
FIG. 43 is a schematic diagram of an application scenario in which a link monitoring method is applicable to a transmitter optical module with a coherent line interface of an 800 G single-wavelength and a transmitter device with a 4*200 G interface according to an embodiment of this application;
FIG. 44 is a schematic diagram of an application scenario in which a link monitoring method is applicable to a receiver optical module with a coherent line interface of an 800 G single-wavelength and a receiver device with a 4*200 G interface according to an embodiment of this application;
FIG. 45 is a schematic diagram of a structure of a link monitoring apparatus according to an embodiment of this application;
FIG. 46 is a schematic diagram of a structure of still another link monitoring apparatus according to an embodiment of this application; and
FIG. 47 is a schematic diagram of a structure of a computer device according to an embodiment of this application.

### DESCRIPTION OF EMBODIMENTS

To make the objectives, technical solutions, and advantages of this application clearer, the following further describes the implementations of this application in detail with reference to the accompanying drawings.

Continuously driven by 5G, cloud computing, big data, and artificial intelligence, an optical communication system and an optical transport network (optical transport network, OTN) are developing towards the trend of large capacity and ultra-high speed. The optical communication system usually uses amplitudes, phases, polarization, or frequencies of optical waves to carry data. During transmission, an optical signal may be distorted due to dispersion, polarization-dependent impairment, noise, non-linear effect, or other factors. In addition, wear and aging of components of an optical network may cause performance deterioration of a transmission system. Forward error correction (forward error correction, FEC) encoding is used to correct transmitted data, to resolve a transmission bit error, and restore raw data from received data. In addition, FEC decoding may further assist in link synchronization and link performance monitoring. Link performance monitoring means monitoring quality of a link for data transmission.

However, there is no effective method for monitoring quality of a link currently.

An embodiment of this application provides a link monitoring method. The link monitoring method may be applied to a transmitter processing module, and the link monitoring method is used to monitor quality of a link for data transmission. In the link monitoring method, outer-code encoded data is received, inner-code encoding is performed on the outer-code encoded data, and inner-code encoded data is output. In addition, outer-code decoding is performed on the outer-code encoded data, and quality of a link for transmission of the outer-code encoded data is determined based on a status of performing outer-code decoding on the outer-code encoded data. This can effectively monitor the quality of the link.

In addition, in the link monitoring method, inner-code encoding needs to be performed on the outer-code encoded data, and the inner-code encoded data is output. In addition, outer-code decoding is performed on the outer-code encoded data, and the quality of the link is determined based on the status of the outer-code decoding. The two processes are separately performed. Therefore, the process of performing outer-code decoding on the data and determining the quality of the link does not affect the process of performing inner-code encoding on the data and outputting the data, and does not additionally increase an overall transmission delay of data. Therefore, the link monitoring method can be applied to more transmission scenarios, and in particular, to a transmission scenario that has a low requirement on a transmission delay.

An embodiment of this application provides another link monitoring method. The link monitoring method may be applied to a receiver processing module, and the link monitoring method is used to monitor quality of a link for data transmission. In the link monitoring method, outer-code encoded and inner-code encoded data is received, inner-code decoding is performed on the outer-code encoded and inner-code encoded data, and inner-code decoded data is output. In addition, outer-code decoding is performed on the inner-code decoded data, and quality of a link for transmission of the outer-code encoded and inner-code encoded data is determined based on a status of performing outer-code decoding on the inner-code decoded data. This can effectively monitor the quality of the link.

In addition, in the link monitoring method, the inner-code decoded data needs to be output. In addition, outer-code decoding needs to be performed on the inner-code decoded data, and the quality of the link is determined based on the status of the outer-code decoding. The two processes are separately performed. Therefore, the process of performing outer-code decoding on the data and determining the quality of the link does not affect the process of outputting the inner-code decoded data, and does not additionally increase an overall transmission delay of data. Therefore, the link monitoring method can be applied to more transmission scenarios, and in particular, to a transmission scenario that has a low requirement on a transmission delay.

An embodiment of this application provides still another link monitoring method. The link monitoring method may be applied to a transmitter processing module, namely, a processing module at a transmitter. The link monitoring method is used to monitor whether de-skewed data meets a processing criterion, and determine, based on a result of monitoring whether the data meets the processing criterion, a method for subsequent de-skewing. In the link monitoring method, outer-code encoded data is received, de-skewing is performed on the outer-code encoded data, inner-code encoding is performed on the outer-code encoded data, and inner-code encoded data is output. In addition, whether the de-skewed data meets the processing criterion is detected, and when the de-skewed data does not meet the processing criterion, a de-skewing method for de-skewing is adjusted.

In the link monitoring method, inner-code encoding needs to be performed on the outer-code encoded data, and the inner-code encoded data is output. In addition, whether the de-skewed data meets the processing criterion needs to be detected. The two processes are separately performed. Therefore, the process of detecting whether the de-skewed data meets the processing criterion does not affect the process of performing inner-code encoding on the data and outputting the data, and does not additionally increase an overall transmission delay of data. Therefore, the link monitoring method can be applied to more transmission scenarios, and in particular, to a transmission scenario that has a low requirement on a transmission delay.

An embodiment of this application provides yet another link monitoring method. The link monitoring method may be applied to a receiver processing module, namely, a processing module at a receiver. The link monitoring method is used to monitor whether de-skewed data meets a processing criterion, and determine, based on a result of monitoring whether the data meets the processing criterion, a method for subsequent de-skewing. In the link monitoring method, outer-code encoded and inner-code encoded data is received, inner-code decoding is performed on the outer-code encoded and inner-code encoded data, and inner-code decoded data is output. In addition, de-skewing is performed on the inner-code decoded data, whether the de-skewed data meets the processing criterion is detected, and when the de-skewed data does not meet the processing criterion, a de-skewing method for de-skewing is adjusted.

In the link monitoring method, the inner-code decoded data needs to be output. In addition, whether the de-skewed data meets the processing criterion needs to be detected. The two processes are separately performed. Therefore, the process of detecting whether the de-skewed data meets the processing criterion does not affect the process of outputting the inner-code decoded data, and does not additionally increase an overall transmission delay of data. Therefore, the link monitoring method can be applied to more transmission scenarios, and in particular, to a transmission scenario that has a low requirement on a transmission delay.

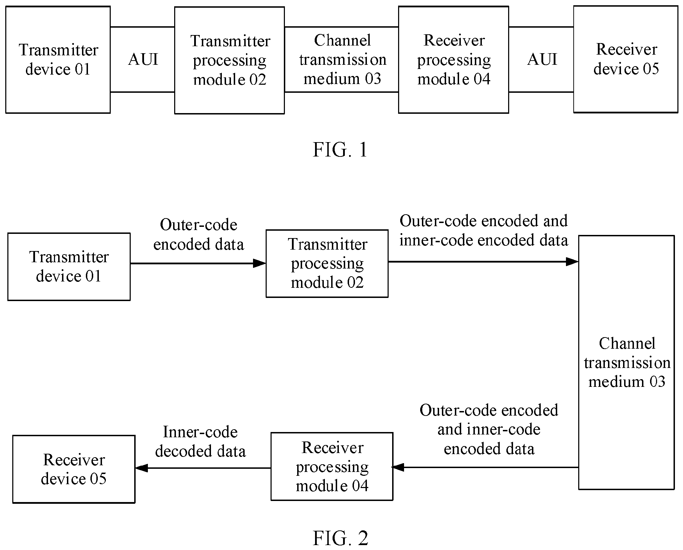

FIG. 1 is a schematic diagram of an implementation environment related to a link monitoring method according to an embodiment of this application. As shown in FIG. 1, the implementation environment includes a transmitter device 01, a transmitter processing module 02, a channel transmission medium 03, a receiver processing module 04, and a receiver device 05. In a data center network, the transmitter device 01 and the receiver device 05 may be devices such as switches or routers. The transmitter device 01 is also referred to as a host chip (host chip) located at a transmitter, the receiver device 05 is also referred to as a host chip located at a receiver, and the channel transmission medium 03 may be an optical fiber. The transmitter device 01 may be connected to the transmitter processing module 02 through an attachment unit interface (attachment unit interface, AUI), and the receiver device 05 may be connected to the receiver processing module 04 through an AUI. The processing module may be an optical module (optical module), an electrical module, or another module that processes data in a data sending process. For example, the processing module may be an 800LR module (800LR module, which is a coherent optical module). In addition, the transmitter device 01, the transmitter processing module 02, the channel transmission medium 03, the receiver processing module 04, and the receiver device 05 in the application scenario may all support bidirectional transmission or unidirectional transmission. This is not specifically limited in embodiments of this application.

FIG. 2 is a schematic flowchart of a data transmission process in the implementation environment shown in FIG. 1 according to an embodiment of this application. As shown in FIG. 2, in a process of transmitting data from the transmitter device 01 to the receiver device 05, the transmitter device 01 is configured to perform outer-code encoding on the data, and then transmit outer-code encoded data to the transmitter processing module 02. The transmitter processing module 02 is configured to: perform inner-code encoding on the outer-code encoded data, to obtain outer-code encoded and inner-code encoded data, and transmit the outer-code encoded and inner-code encoded data to the channel transmission medium 03. The channel transmission medium 03 is configured to transmit the outer-code encoded and inner-code encoded data to the receiver processing module 04. The receiver processing module 04 is configured to perform inner-code decoding on the outer-code encoded and inner-code encoded data, and transmit, to the receiver device 05, data (data on which outer-code decoding is to be performed) on which inner-code decoding is performed. The receiver device 05 is configured to perform outer-code decoding on the inner-code decoded data. Both the transmitter processing module 02 and the receiver processing module 04 are further configured to monitor quality of a link for data transmission. In addition, both the transmitter processing module 02 and the receiver processing module 04 are further configured to: perform de-skewing on a signal, monitor whether de-skewed data meets a processing criterion, and determine, based on a result of monitoring whether the data meets the processing criterion, a method for subsequent de-skewing.

"Inner" in "inner code" and "outer" in "outer code" indicate a distance between an execution body that performs an operation on data and the channel transmission medium 03. The execution body that performs an operation on an inner code is closer to the channel transmission medium, and the execution body that performs an operation on an outer code is farther away from the channel transmission medium. In embodiments of this application, data is transmitted from the transmitter device 01 to the channel transmission medium 03 via the transmitter processing module 02, and then transmitted from the channel transmission medium 03 to the receiver device 05 via the receiver processing module 04. Compared with data encoded by the transmitter processing module 02, data encoded by the transmitter device 01 is farther away from the channel transmission medium 03. Compared with the data decoded by the receiver processing module 04, the data decoded by the receiver device 05 is farther away from the channel transmission medium 03. Therefore, the data encoded by the transmitter device 01 is referred to as outer-code encoded data, and the data encoded by the transmitter processing module 02 is referred to as inner-code encoded data; the data decoded by the receiver device 05 is referred to as outer-code decoded data, and the data decoded by the receiver processing module 04 is referred to as inner-code decoded data.

It should be understood that the foregoing content is an example of the application scenario of the link monitoring method provided in embodiments of this application, and does not constitute any limitation on the application scenario of the link monitoring method. A person of ordinary skill in the art may learn that, as a service requirement changes, the application scenario of the link monitoring method may be adjusted depending on an application requirement. Application scenarios are not enumerated in embodiments of this application.

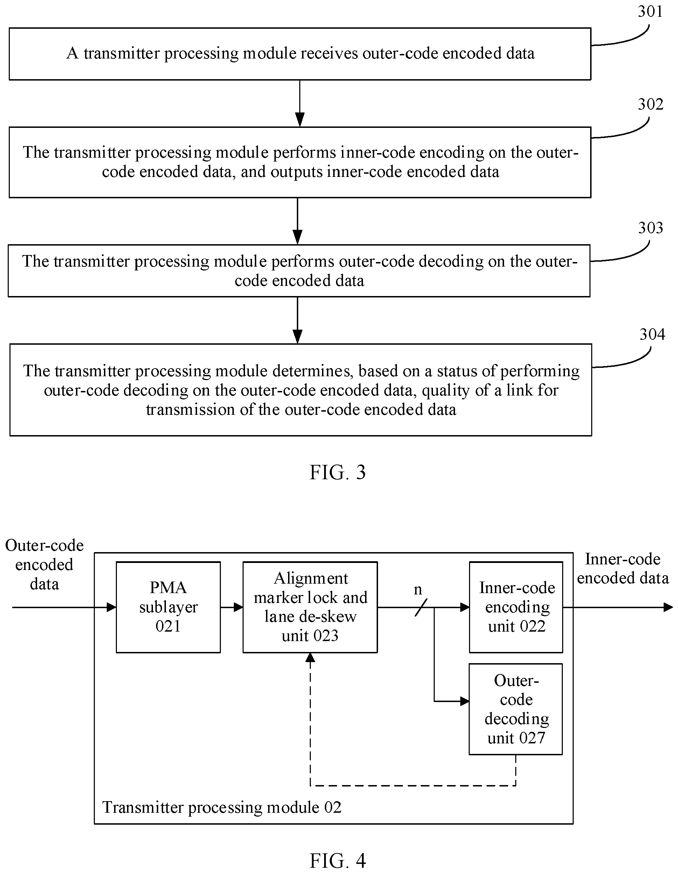

The following describes an implementation process of a link monitoring method according to an embodiment of this application. The following first describes a link monitoring method applied to a transmitter processing module. The link monitoring method is used for monitoring quality of a link for data transmission. As shown in FIG. 3, the implementation process of the link monitoring method includes the following steps.

Step 301: A transmitter processing module receives outer-code encoded data.

In an implementation, as shown in FIG. 4, a physical medium attachment (physical medium attachment, PMA) sublayer 021 is disposed in the transmitter processing module 02. That the transmitter processing module receives the outer-code encoded data is essentially that the PMA sublayer receives, through an interface (for example, an AUI) between the transmitter processing module and a transmitter device, the data outer-code encoded by the transmitter device. In addition, after receiving the outer-code encoded data, the PMA sublayer may perform demultiplexing on the outer-code encoded data, to obtain n physical coding sublayer lane (physical coding sublayer lane, PCSL) data streams, so as to perform de-skewing (de-skew) on the n PCSL data streams.

Step 302: The transmitter processing module performs inner-code encoding on the outer-code encoded data, and outputs inner-code encoded data.

After receiving the outer-code encoded data, the transmitter processing module may perform inner-code encoding on the outer-code encoded data, and output the inner-code encoded data, to transmit, through a channel transmission medium (for example, an optical fiber), the inner-code encoded data to a receiver processing module. A bit error caused during data transmission through the interface between the transmitter processing module and the transmitter device is sent for inner-code encoding without being eliminated through outer-code decoding. As shown in FIG. 4, an inner-code encoding unit 022 is disposed in the transmitter processing module 02, and the inner-code encoding unit 022 is configured to perform inner-code encoding. That the transmitter processing module performs inner-code encoding on the outer-code encoded data is essentially using an inner-code encoding manner to obtain inner-code check data of the outer-code encoded data, and adding the inner-code check data to the outer-code encoded data. That the transmitter processing module outputs the inner-code encoded data is essentially outputting outer-code encoded data including the check data, and is also referred to as outputting outer-code encoded and inner-code encoded data.

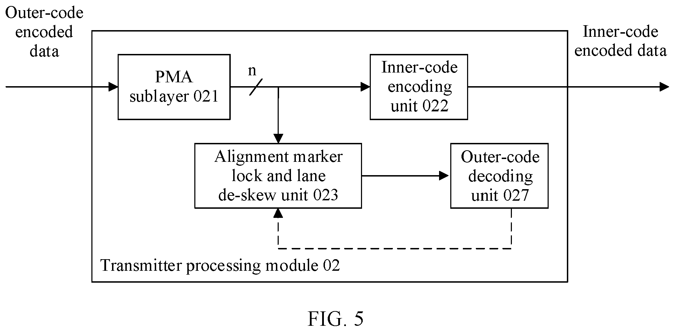

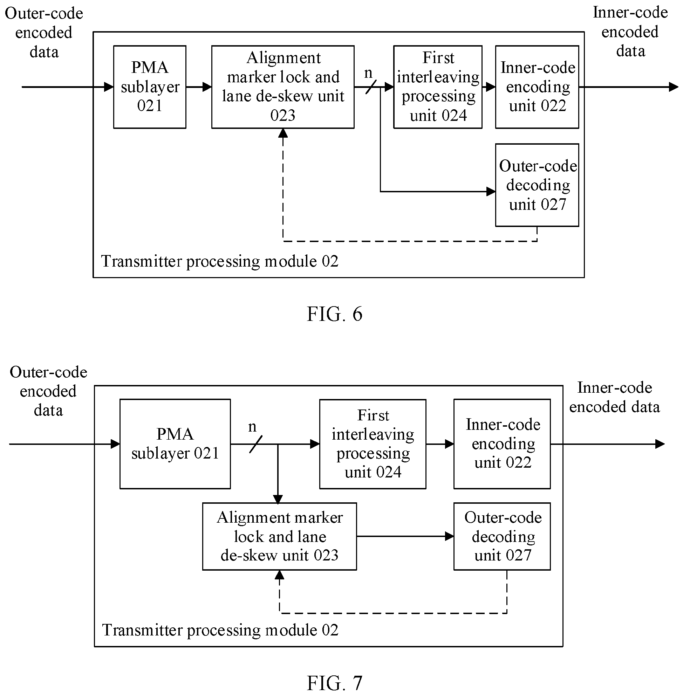

Optionally, specific implementations of objects (namely, data on which inner-code encoding is performed) on which inner-code encoding is performed by the transmitter processing module vary with different application scenarios. In a case, the data on which inner-code encoding is performed may be data on which outer-code encoding and de-skewing are performed. In an implementation, as shown in FIG. 4, an alignment marker lock and lane de-skew (alignment marker lock and lane de-skew) unit 023 is disposed in the transmitter processing module 02. The alignment marker lock and lane de-skew unit 023 is configured to perform de-skewing on data. For example, as shown in FIG. 4, after receiving the outer-code encoded data, the transmitter processing module 02 may first perform de-skewing on the outer-code encoded data, and then perform inner-code encoding on de-skewed data. In another case, the inner-code encoded data may directly be data on which outer-code encoding is performed. For example, as shown in FIG. 5, after receiving the outer-code encoded data, the transmitter processing module 02 may directly perform inner-code encoding on the outer-code encoded data. In still another case, the inner-code encoded data may be data on which outer-code encoding and data processing are performed. In an implementation, the data processing includes first interleaving. For example, as shown in FIG. 6, after receiving the outer-code encoded data, the transmitter processing module 02 may first perform de-skewing on the outer-code encoded data, perform first interleaving on de-skewed data, and then perform inner-code encoding on data on which first interleaving is performed. For example, as shown in FIG. 7, after receiving the outer-code encoded data, on one hand, the transmitter processing module 02 may perform de-skewing on the outer-code encoded data; on the other hand, the transmitter processing module may perform first interleaving on the outer-code encoded data, and then perform inner-code encoding on data on which first interleaving is performed. In addition, as shown in FIG. 6 and FIG. 7, a first interleaving processing unit 024 is disposed in the transmitter processing module 02, and the first interleaving processing unit 024 is configured to perform first interleaving.

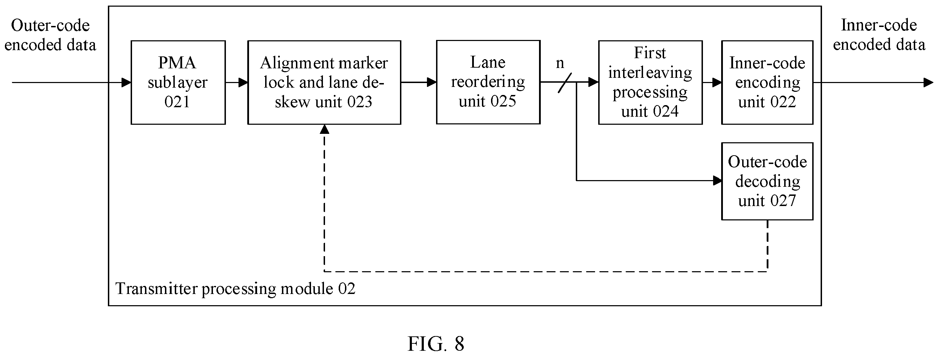

It should be noted that the de-skewed data usually includes a plurality of lanes of data. When a de-skewing process is performed before a process of inner-code encoding and outputting, after de-skewing and before inner-code encoding, the transmitter processing module may further perform lane reordering (lane reorder) on the data. In other words, the inner-code encoded data may be data on which outer-code encoding, de-skewing, and lane reordering are performed. Lane reordering means reordering data of a plurality of lanes based on alignment markers of the data of the plurality of lanes, so that the data of the plurality of lanes can be arranged in a specified sequence. In addition, two types of processing may be performed on the data on which de-skewing and lane reordering are performed. One type of processing is inner-code encoding, and the other type of processing is outer-code decoding. As shown in FIG. 8, a lane reordering unit 025 is disposed in the transmitter processing module 02. The lane reordering unit 025 is configured to perform lane reordering on data.

In this way, regardless of a sequence of the data of the plurality of lanes obtained by the transmitter processing module, lane reordering is performed on the data, and then inner-code encoding is performed on lane-reordered data, so that the inner-code encoded data that is output by the transmitter processing module is ordered based on a sequence specified in lane reordering. Therefore, when a performance test is performed on the transmitter processing module, different transmitter processing modules of a same type have same output data when input data is the same. This facilitates the performance test of the transmitter processing module. In addition, if first interleaving further needs to be performed on the data before inner-code encoding is performed on the data, because all data on which lane reordering is to be performed can be ordered based on the sequence specified in lane reordering, a sequence of the data on which first interleaving is performed is fixed. This facilitates design of a first interleaving processing unit.

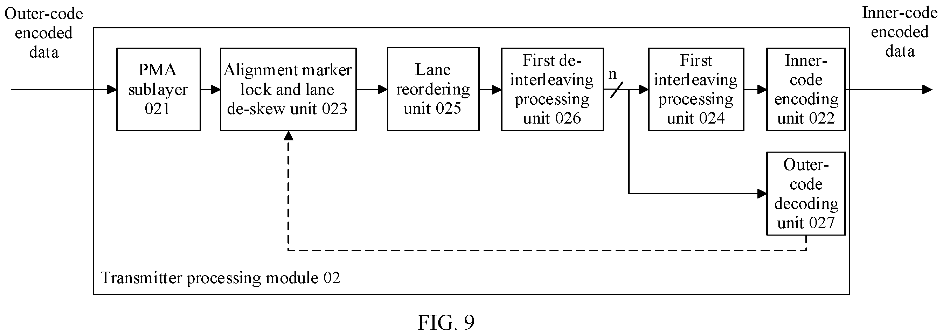

In addition, after performing lane reordering on the data, the transmitter processing module may first perform first de-interleaving (de-interleave) on the data. In other words, the inner-code encoded data is data on which outer-code encoding, de-skewing, lane reordering, and first de-interleaving are performed. In addition, two types of processing may be performed on the data on which de-skewing, lane reordering, and first de-interleaving are performed. One type of processing is inner-code encoding, and the other type of processing is outer-code decoding. After performing outer-code encoding on the data, the transmitter device performs second interleaving on the outer-code encoded data, and then outputs data on which second interleaving is performed. The first de-interleaving is inverse processing of the second interleaving. First de-interleaving is performed on the data, to obtain a codeword stream based on a plurality of lanes of data. If the outer-code encoded data is data on which RS encoding is performed, the codeword stream is a stream of RS codewords (stream of Reed-Solomon codewords). In an implementation, the transmitter processing module may first perform lane reordering on de-skewed data, perform first de-interleaving on lane-reordered data, and then perform inner-code encoding on data on which first de-interleaving is performed. Alternatively, the transmitter processing module may first perform lane reordering on de-skewed data, perform first de-interleaving on lane-reordered data, perform first interleaving on data on which first de-interleaving is performed, and then perform inner-code encoding on data on which first interleaving is performed. As shown in FIG. 9, a first de-interleaving processing unit 026 is disposed in the transmitter processing module, and the first de-interleaving processing unit 026 is configured to perform first de-interleaving on data.

In addition, before transmitting the inner-code encoded data to the channel transmission medium, the transmitter processing module may further perform some data processing on the inner-code encoded data. For example, data processing such as modulation mapping or channel interleaving may be first performed on the inner-code encoded data, and then data-processed data is transmitted to the channel transmission medium.

In an implementation, an implementation process of performing de-skewing on the n PCSL data streams may include: obtaining alignment markers (alignment marker, AM) of the n PCSL data streams; performing alignment marker locking on the n PCSL data streams based on the alignment markers of the n PCSL data streams; and after determining that the alignment markers of the n PCSL data streams are all valid, performing de-skewing on the n PCSL data streams based on the alignment markers of the n PCSL data streams.

For different transmission scenarios, standard alignment markers of n1 PCSL data streams in a corresponding transmission scenario are defined in a communication standard. In this way, an implementation of determining that markers of the n1 PCSL data streams are all valid includes: matching the alignment markers of the n1 PCSL data streams received by the transmitter processing module with the standard alignment markers of the n1 PCSL data streams defined in the communication standard; and when the alignment markers of the n1 PCSL data streams received by the transmitter processing module match the standard alignment markers of the n1 PCSL data streams one by one, determining that the markers of the n1 PCSL data streams are all valid. When interfaces (for example, an AUI) between the transmitter processing module and the transmitter device are p parallel interfaces, the processing module may divide the n PCSL data streams into p data streams, and each data stream includes n1 PCSL data streams, where n=n1*p, p is a positive integer, and n1 is a positive integer. It is separately determined, based on the foregoing descriptions, that alignment markers of the n1 PCSL data streams in each data stream are all valid. Then, de-skewing is performed on the n PCSL data streams based on the alignment markers of all the n PCSL data streams, or de-skewing is separately performed on the p data streams.

It should be noted that, to ensure that effective de-skewing can be performed on the data, the transmitter processing module may determine, according to some policies, a de-skewing method for performing de-skewing on the data. For example, the transmitter processing module may first perform de-skewing on the data, and then detect whether de-skewed data meets a processing criterion. When the de-skewed data does not meet the processing criterion, the transmitter processing module adjusts the de-skewing method for de-skewing until the de-skewed data meets the processing criterion, and performs de-skewing on the data by using a de-skewing method using which the processing criterion is met. To improve readability of this embodiment of this application, an implementation process of the process is not described in detail herein. For the implementation process of the process, refer to related descriptions of step 3201 to step 3205 in the following content.

Step 303: The transmitter processing module performs outer-code decoding on the outer-code encoded data.

The transmitter processing module may perform outer-code decoding on the outer-code encoded data, and determine, based on a status of outer-code decoding, quality of a link for transmission of the outer-code encoded data. In addition, on one hand, the transmitter processing module performs inner-code encoding on the outer-code encoded data, and outputs inner-code encoded data. On the other hand, the transmitter processing module performs outer-code decoding on the outer-code encoded data, and then determines the quality of the link based on the status of the outer-code decoding. In other words, the transmitter processing module performs inner-code encoding on the outer-code encoded data, and outputs the inner-code encoded data. In addition, the transmitter processing module performs outer-code decoding on the outer-code encoded data, and determines the quality of the link. The two processes are respectively performed on two processing lanes. In this way, a process of performing outer-code decoding on the outer-code encoded data and determining the quality of the link does not affect a process of performing inner-code encoding on the outer-code encoded data and outputting the inner-code encoded data, and does not additionally increase a transmission delay of data, to effectively reduce an overall transmission delay of the data. Optionally, as shown in FIG. 4 to FIG. 9, an outer-code decoding unit 027 is disposed in the transmitter processing module 02, and the outer-code decoding unit 027 is configured to: perform outer-code decoding on the outer-code encoded data, and determine, based on the status of performing outer-code decoding on the outer-code encoded data, the quality of the link for transmission of the outer-code encoded data.

Optionally, specific implementations of the outer-code decoded data vary with different application scenarios. In a case, the outer-code decoded data may be data on which outer-code encoding and de-skewing are performed. For example, as shown in FIG. 4 to FIG. 9, after receiving the outer-code encoded data, the transmitter processing module 02 may first perform de-skewing on the outer-code encoded data, and then perform outer-code decoding on de-skewed data. In addition, when the inner-code encoded data is the data on which outer-code encoding and de-skewing are performed, and the outer-code decoded data is the data on which outer-code encoding and de-skewing are performed, de-skewing may be performed after the transmitter processing module receives the outer-code encoded data. After de-skewing is performed, two types of processing may be performed on de-skewed data. One type of processing is that the transmitter processing module performs inner-code encoding and outputs data, and the other type of processing is that the transmitter processing module performs outer-code decoding. De-skewing is first performed on the outer-code encoded data, outer-code decoding is performed on the de-skewed data, and then the quality of the link for transmission of the outer-code encoded data is determined based on the status of the outer-code decoding. Because data for determining the quality of the link is the de-skewed data, accuracy of the quality of the link determined based on the data can be effectively ensured.

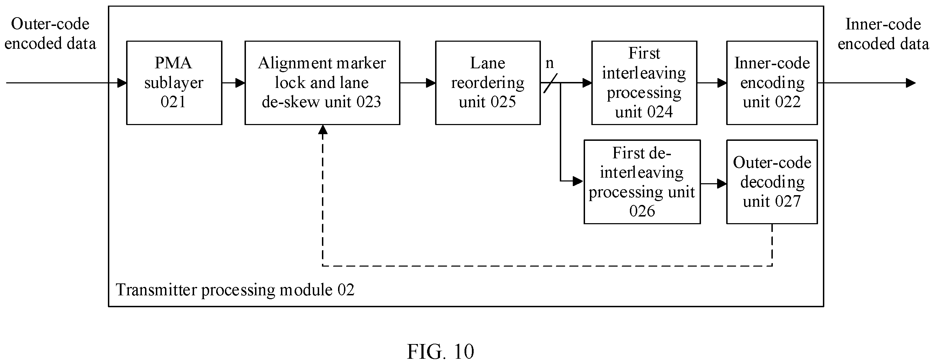

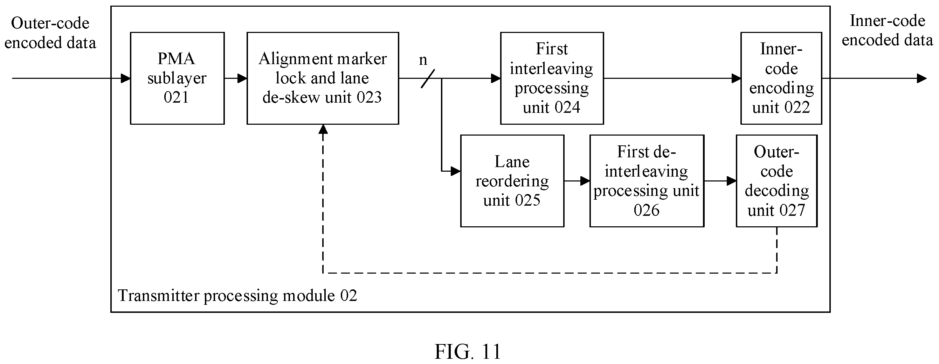

In another case, the outer-code decoded data may be data on which outer-code encoding, lane reordering, and first de-interleaving are performed. For example, as shown in FIG. 9, FIG. 10, FIG. 11, and FIG. 12, after receiving the outer-code encoded data, the transmitter processing module 02 may first perform de-skewing and lane reordering on the outer-code encoded data, perform first de-interleaving on lane-reordered data, and then perform outer-code decoding on data on which first de-interleaving is performed.

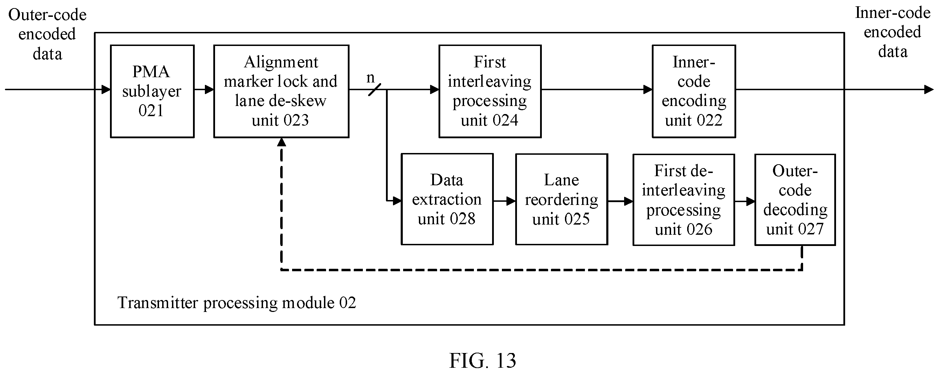

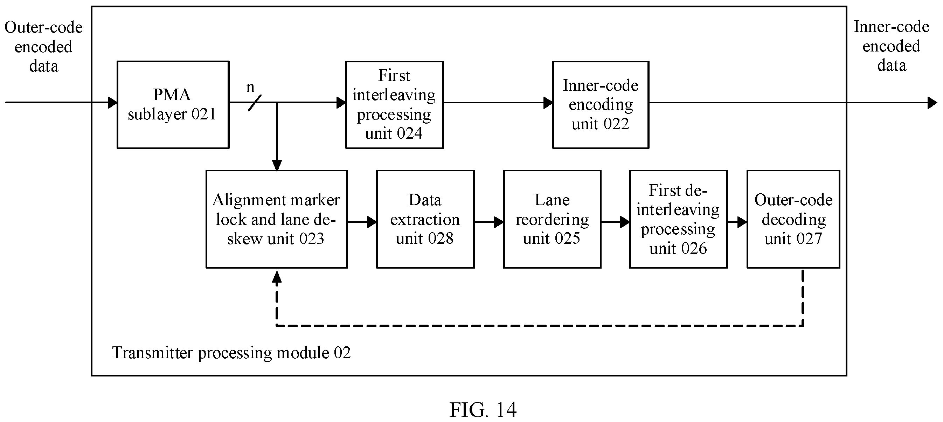

In yet another case, the outer-code decoded data may be data on which outer-code encoding and data extraction are performed. For example, as shown in FIG. 13, FIG. 14, and FIG. 15, after receiving the outer-code encoded data, the transmitter processing module 02 may first perform data extraction on the outer-code encoded data, and then perform outer-code decoding on data-extracted data.

For implementations of performing de-skewing on the data, performing lane reordering on the data, and performing first de-interleaving on the data, refer to related descriptions in the foregoing content. Details are not described herein again. In addition, the outer-code decoded data may alternatively be data on which de-skewing, data extraction, lane reordering, and first de-interleaving are performed, and an execution sequence of a plurality of types of processing such as de-skewing, data extraction, lane reordering, and first de-interleaving may be adjusted depending on an application requirement.

Performing data extraction on the data means to extract a part of data streams from the data according to a preset rule. In an implementation, as shown in FIG. 13, FIG. 14, and FIG. 15, a data extraction unit 028 is disposed in the transmitter processing module 02. The data extraction unit 028 can extract a part of data streams from the data according to the preset rule, and output a data stream on which data extraction is performed.

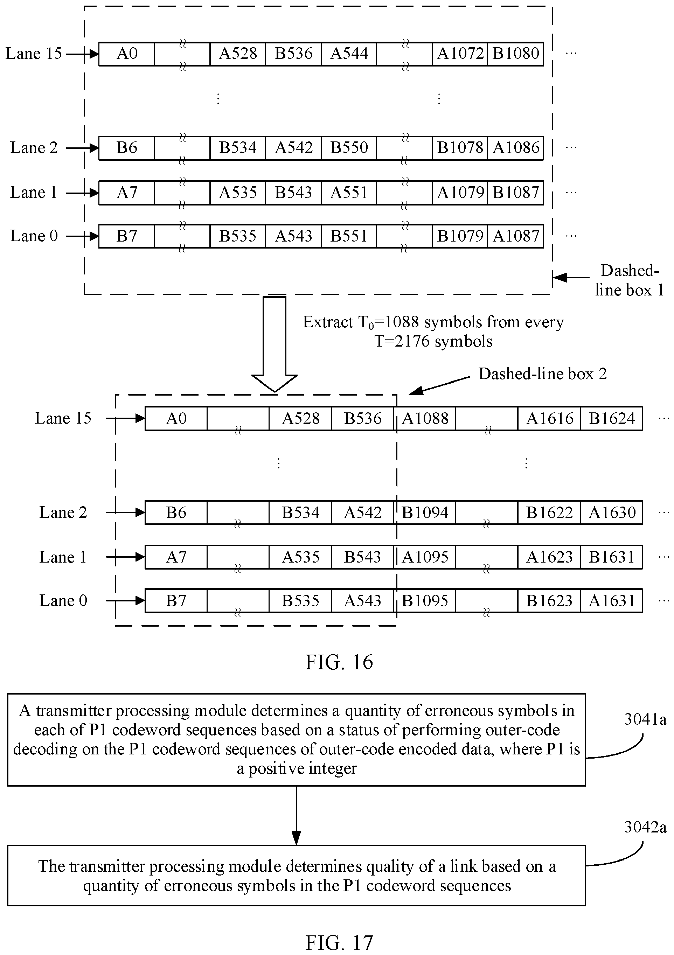

Optionally, the preset rule for data extraction may be: T0 symbols are selected from every T symbols in the data, where the T0 symbols need to include at least one complete codeword sequence, to ensure that a data stream on which data extraction is performed can be decoded. T ≥ T0, and T and T0 are positive integers. Values of T and T0 may be determined depending on an application requirement. For example, FIG. 16 shows data with 16 PCSL data streams. It is considered that a code length of an outer code is 544 symbols, symbols A0, A1, A2, and the like in the data stream indicate that the symbols are from one codeword data stream, and A0, A1, ..., and A543 constitute a codeword; symbols B0, B1, B2, and the like in the data stream indicate that the symbols are from another codeword data stream, and B0, B1, ..., and B543 constitute a codeword. Before data extraction, symbols transmitted in each data lane are arranged in a manner shown in a dashed-line box 1 in FIG. 16. In this case, T may be 2176, and T0 may be 1088. After data extraction is performed based on the values of T and T0, extracted data includes symbols in a dashed-line box 2 in FIG. 16.

It should be noted that, when T > T0, a rate of the data obtained through data extraction can be less than a rate of the data inner-code encoded by the transmitter processing module. This can reduce a rate of a de-skewed signal, and implement monitoring with low power consumption. When T = T0, because input data and output data of the data extraction unit are basically the same, it may be considered that no data extraction unit is set. Correspondingly, in this case, the data extraction unit may also be removed.

Step 304: The transmitter processing module determines, based on the status of performing outer-code decoding on the outer-code encoded data, the quality of the link for transmission of the outer-code encoded data.

In an implementation, as shown in FIG. 17, an implementation process of step 304 includes the following steps.

Step 3041a: The transmitter processing module determines a quantity of erroneous symbols in each of P1 codeword sequences based on a status of performing outer-code decoding on the P1 codeword sequences of the outer-code encoded data, where P1 is a positive integer.

The transmitter processing module may determine, based on a status of decoding a codeword sequence of the outer-code encoded data, a quantity of erroneous symbols in the codeword sequence. In an implementation, if it is determined, based on the status of the outer-code decoding, that the codeword sequence can be successfully decoded (that is, correctable), a total quantity of symbols that are corrected in the codeword sequence during decoding may be denoted as the quantity of erroneous symbols in the codeword sequence. If it is determined, based on the status of the outer-code decoding, that the codeword sequence cannot be successfully decoded (that is, uncorrectable (uncorrectable)), it may be considered that the quantity of erroneous symbols in the codeword sequence exceeds a quantity t of erroneous symbols corresponding to a maximum decoding correction capability. In this case, the quantity of erroneous symbols in the codeword sequence may be denoted as t+1. For example, when KP4 RS (544, 514) code is used as an outer code, a quantity of erroneous symbols corresponding to the maximum decoding correction capability is 15. If a received codeword sequence is correctable, a total quantity of corrected symbols in the codeword sequence during decoding may be denoted as a quantity of erroneous symbols in the codeword sequence. If the received codeword sequence is uncorrectable, a quantity of erroneous symbols in the codeword sequence may be denoted as 16.

The transmitter processing module may determine, based on a quantity of erroneous symbols in one or more (namely, P1) codeword sequences of the outer-code encoded data, the quality of the link for transmission of the outer-code encoded data. In this case, the transmitter processing module needs to separately determine the quantity of erroneous symbols in each of the P1 codeword sequences. In addition, when the quality of the link is determined based on the quantity of erroneous symbols in the plurality of codeword sequences of the outer-code encoded data, because the quantity of erroneous symbols in the plurality of codeword sequences can more comprehensively reflect impact of the codeword sequences on the link, the quality of the link can be monitored more accurately.

It should be noted that the "quantity of erroneous symbols in the codeword sequence" in the foregoing descriptions is a quantity of erroneous symbols in a codeword sequence detected by a decoder, and may be equal or unequal to a quantity of actual erroneous symbols in the codeword sequence.

Step 3042a: The transmitter processing module determines the quality of the link based on a quantity of erroneous symbols in the P1 codeword sequences.

Because the quantity of erroneous symbols in the codeword sequence can reflect impact of the codeword sequence on the link, the transmitter processing module may determine the quality of the link based on the quantity of erroneous symbols in the codeword sequence. In an implementation, the transmitter processing module may calculate a sum of the quantity of erroneous symbols in the P1 codeword sequences of the outer-code encoded data, and determine the quality of the link based on the sum. For example, the sum may be compared with a preset threshold. When the sum is greater than the threshold (exceed the threshold), it is determined that the quality of the link is degraded, that is, link degradation (link degrade) occurs on the link. When the sum is less than or equal to the threshold, it is determined that the quality of the link is not degraded. The threshold may be determined depending on an application requirement. In addition, a plurality of levels may be set for the quality of the link, and corresponding thresholds are respectively set for the plurality of levels. When the sum is within a range limited by a threshold, it is determined that the quality of the link is a quality level corresponding to the threshold.

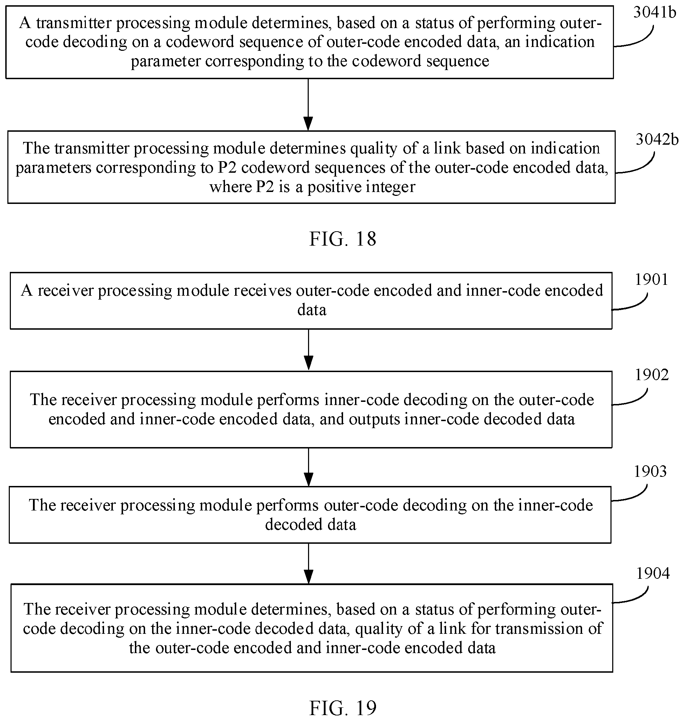

In another implementation, as shown in FIG. 18, an implementation process of step 304 includes the following steps.

Step 3041b: The transmitter processing module determines, based on a status of performing outer-code decoding on a codeword sequence of the outer-code encoded data, an indication parameter corresponding to the codeword sequence.

An implementation process of step 3041b includes: The transmitter processing module determines, based on the status of the outer-code decoding, a quantity of erroneous symbols in the codeword sequence of the outer-code encoded data, and then determines the indication parameter of the codeword sequence based on the quantity of erroneous symbols in the received codeword sequence. For an implementation in which the transmitter processing module determines the quantity of erroneous symbols in the codeword sequence based on the status of the outer-code decoding, refer to related descriptions in step 3041a. In an implementation, the determining the indication parameter of the codeword sequence based on the quantity of erroneous symbols in the codeword sequence includes: comparing the quantity of erroneous symbols in the codeword sequence with a preset first threshold; and when the quantity of erroneous symbols in the codeword sequence is less than or equal to the first threshold, setting the indication parameter corresponding to the codeword sequence to Q0; or when the quantity of erroneous symbols in the codeword sequence is greater than the first threshold, setting the indication parameter corresponding to the codeword sequence to Q1. A value of Q0 is less than a value of Q1, and the first threshold, the value of Q0, and the value of Q1 may be determined depending on an application requirement. For example, the value of Q0 may be 0, and the value of Q1 may be 1.

Step 3042b: The transmitter processing module determines the quality of the link based on indication parameters corresponding to P2 codeword sequences of the outer-code encoded data, where P2 is a positive integer.

In an implementation, the transmitter processing module may calculate a sum of the indication parameters corresponding to the P2 codeword sequences of the outer-code encoded data, and determine the quality of the link based on the sum. For example, the sum may be compared with a preset second threshold. When the sum is greater than the second threshold, it is determined that the quality of the link is degraded, that is, link degradation occurs on the link. When the sum is less than or equal to the second threshold, it is determined that the quality of the link is not degraded. The second threshold may be determined depending on an application requirement. In addition, a plurality of levels may be set for the quality of the link, and corresponding thresholds are respectively set for the plurality of levels. When the sum is within a range limited by a threshold, it is determined that the quality of the link is a quality level corresponding to the threshold. In addition, P2 may be a positive integer greater than 1. When the quality of the link is determined based on the quantity of erroneous symbols in the plurality of codeword sequences of the outer-code encoded data, because the quantity of erroneous symbols in the plurality of codeword sequences can more comprehensively reflect impact of the codeword sequences on the link, the quality of the link can be monitored more accurately.

In conclusion, in the link monitoring method, outer-code decoding is performed on the outer-code encoded data, and the quality of the link for transmission of the outer-code encoded data is determined based on the status of performing outer-code decoding on the outer-code encoded data. This can effectively monitor the quality of the link.

In addition, inner-code encoding needs to be performed on the outer-code encoded data, and the inner-code encoded data is output. In addition, outer-code decoding is performed on the outer-code encoded data, and the quality of the link is determined based on the status of the outer-code decoding. The two processes are separately performed. Therefore, the process of performing outer-code decoding on the data and determining the quality of the link does not affect the process of performing inner-code encoding on the data and outputting the data, and does not additionally increase a transmission delay of data. Therefore, the link monitoring method can be applied to more transmission scenarios, and in particular, to a transmission scenario that has a low requirement on a transmission delay.

The following describes a link monitoring method applied to a receiver processing module. The link monitoring method is used for monitoring quality of a link for data transmission. As shown in FIG. 19, an implementation process of the link monitoring method includes the following steps.

Step 1901: A receiver processing module receives outer-code encoded and inner-code encoded data.

The receiver processing module is connected to a transmitter processing module via a channel transmission medium (for example, an optical fiber). After the transmitter processing module outputs the outer-code encoded and inner-code encoded data, the receiver processing module may receive, from the channel transmission medium, the outer-code encoded and inner-code encoded data. In addition, after receiving the outer-code encoded and inner-code encoded data, the receiver processing module may process the data (for example, perform channel de-interleaving and demodulation on the data), to obtain a data stream, so as to further process the data stream.

Step 1902: The receiver processing module performs inner-code decoding on the outer-code encoded and inner-code encoded data, and outputs inner-code decoded data.

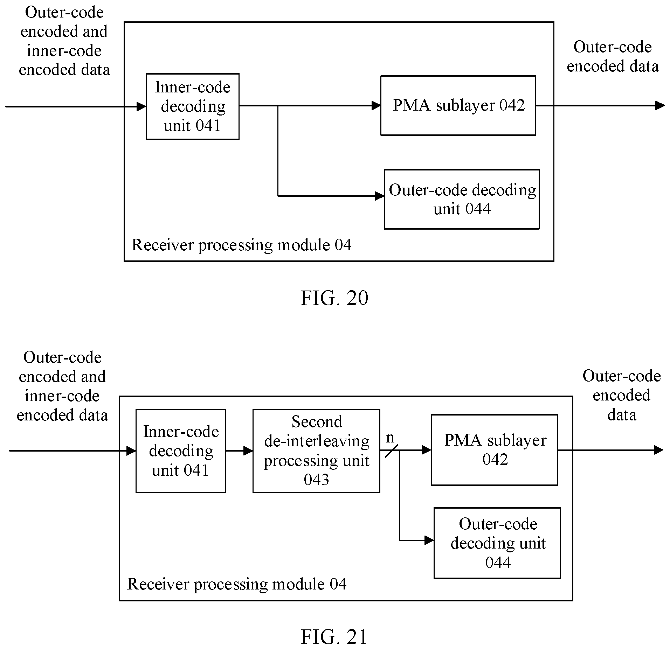

After receiving the outer-code encoded and inner-code encoded data, the receiver processing module may perform inner-code decoding on the data, to eliminate at least a portion of bit errors caused during transmission of the data in the channel transmission medium, and output the inner-code decoded data, so as to complete processing and transmission of the data in the receiver processing module. In an implementation, as shown in FIG. 20, an inner-code decoding unit 041 and a PMA sublayer 042 are disposed in the receiver processing module 04. The inner-code decoding unit 041 is configured to perform inner-code decoding on the outer-code encoded and inner-code encoded data. That the receiver processing module outputs the inner-code decoded data is essentially that the PMA sublayer 042 transmits, through an interface (for example, an AUI) between the receiver processing module and a receiver device, the inner-code decoded data to the receiver device.

Optionally, specific implementations of the data (namely, the output data) output by the receiver processing module vary with different application scenarios. In a case, the data output by the receiver processing module may directly be inner-code decoded data. For example, as shown in FIG. 20, after performing inner-code decoding on the outer-code encoded and inner-code encoded data, the receiver processing module 04 may directly output the inner-code decoded data.

In another case, before performing inner-code encoding on the data, the transmitter processing module may perform data processing on the data, so that the outer-code encoded and inner-code encoded data may be data-processed data. Therefore, the data output by the receiver processing module may be data on which inner-code decoding and inverse processing of the data processing are performed. In an implementation, the data processing may include first interleaving, and the inverse processing of the data processing may include second de-interleaving. For example, as shown in FIG. 21, after receiving the outer-code encoded and inner-code encoded data, the receiver processing module 04 may first perform inner-code decoding on the outer-code encoded and inner-code encoded data, perform second de-interleaving on the inner-code decoded data, and then output data on which second de-interleaving is performed. In addition, as shown in FIG. 21, a second de-interleaving processing unit 043 is disposed in the receiver processing module 04. The second de-interleaving processing unit 043 is configured to perform de-interleaving on the inner-code decoded data. For an implementation of performing second de-interleaving on the data, refer to related descriptions about de-interleaving in the foregoing content. Details are not described herein again.

Step 1903: The receiver processing module performs outer-code decoding on the inner-code decoded data.

The receiver processing module may perform outer-code decoding on the inner-code decoded data, and determine, based on a status of outer-code decoding, quality of a link for transmission of the outer-code encoded and inner-code encoded data. In addition, on one hand, the receiver processing module outputs the inner-code decoded data. On the other hand, the receiver processing module performs outer-code decoding on the inner-code decoded data, and determines the quality of the link based on the status of the outer-code decoding. In other words, the receiver processing module outputs the inner-code decoded data. In addition, the receiver processing module performs outer-code decoding, and determines the quality of the link. The two processes are separately performed on two processing lanes. In this way, the process of performing outer-code decoding and determining the quality of the link does not affect the process of outputting the inner-code decoded data, and does not additionally increase an overall transmission delay of data, to effectively reduce an overall transmission delay of the data. As shown in FIG. 20 and FIG. 21, an outer-code decoding unit 044 is disposed in the receiver processing module 04, and the outer-code decoding unit 044 is configured to perform outer-code decoding on data.

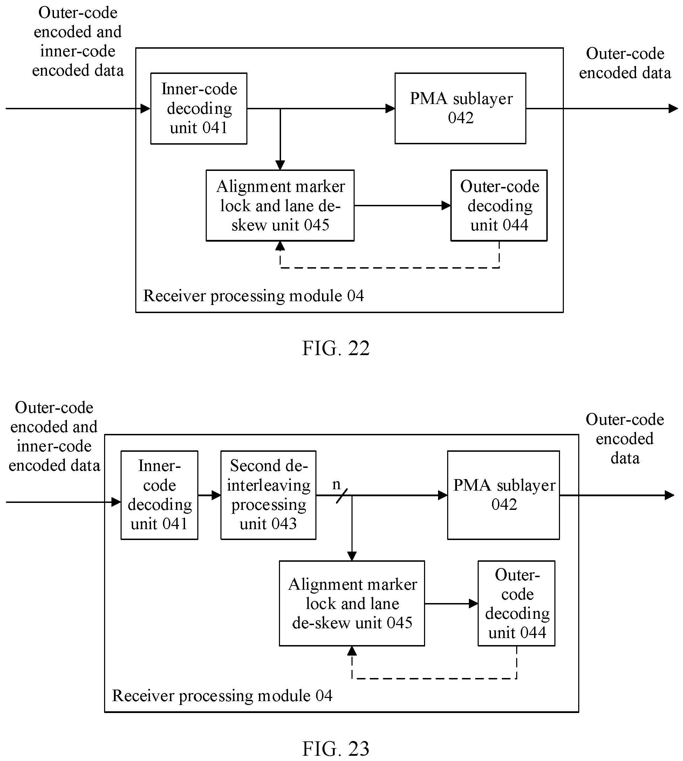

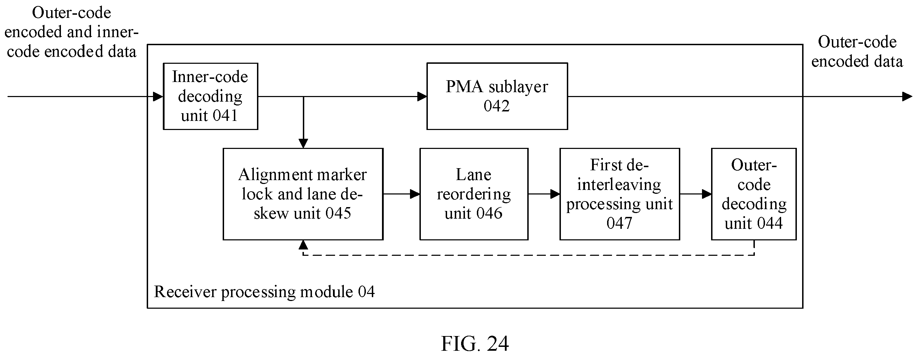

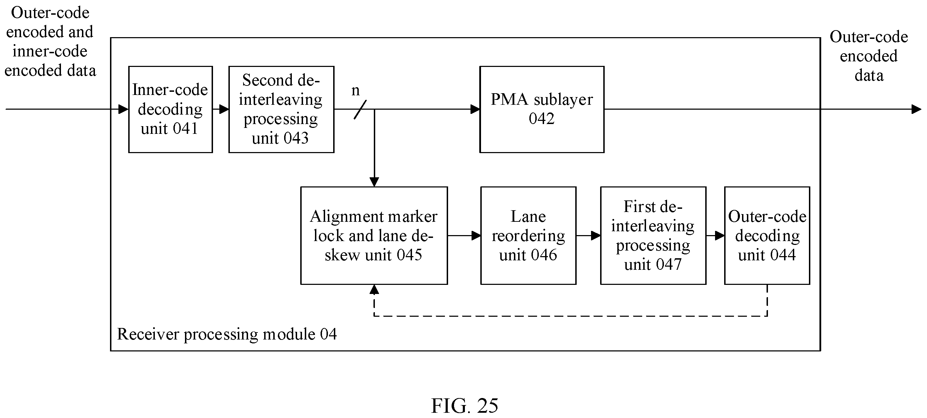

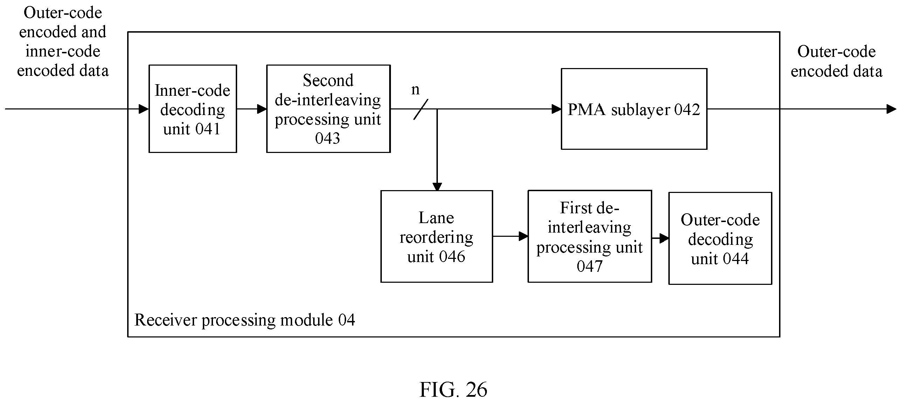

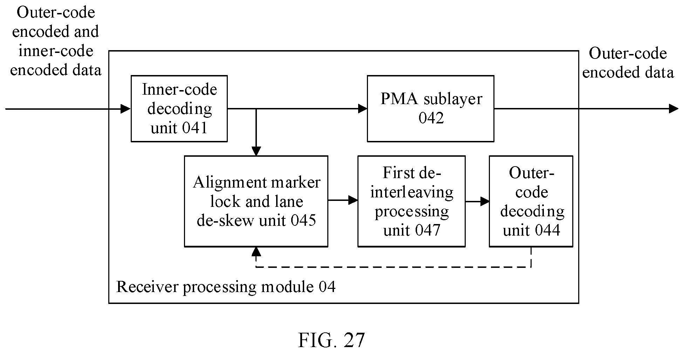

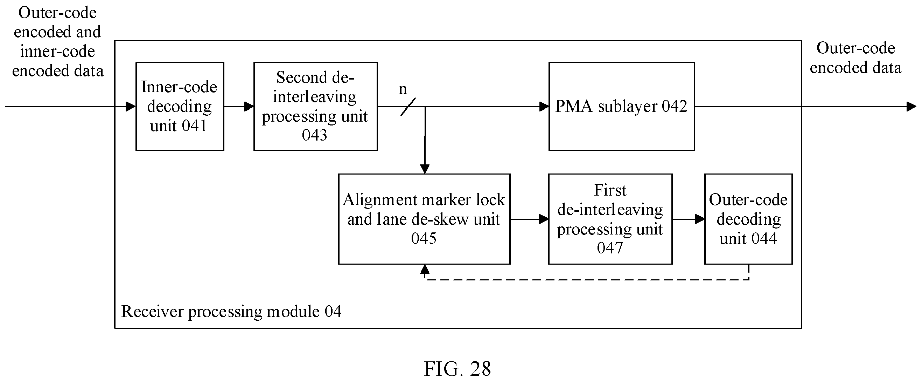

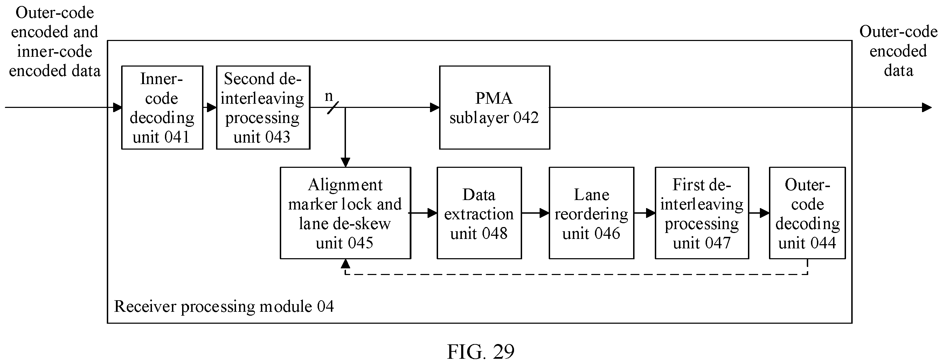

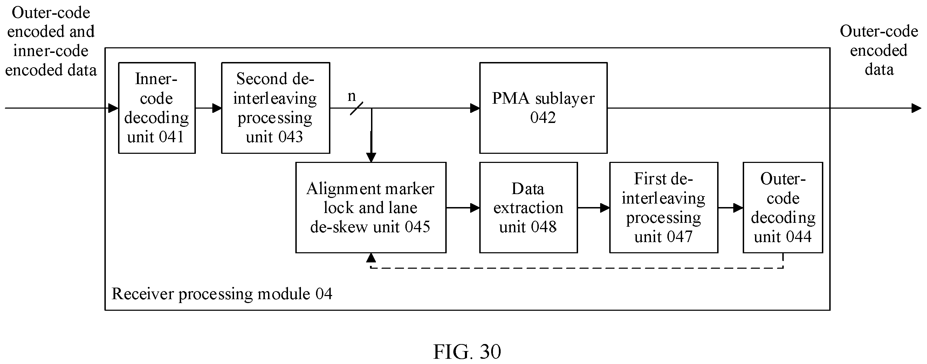

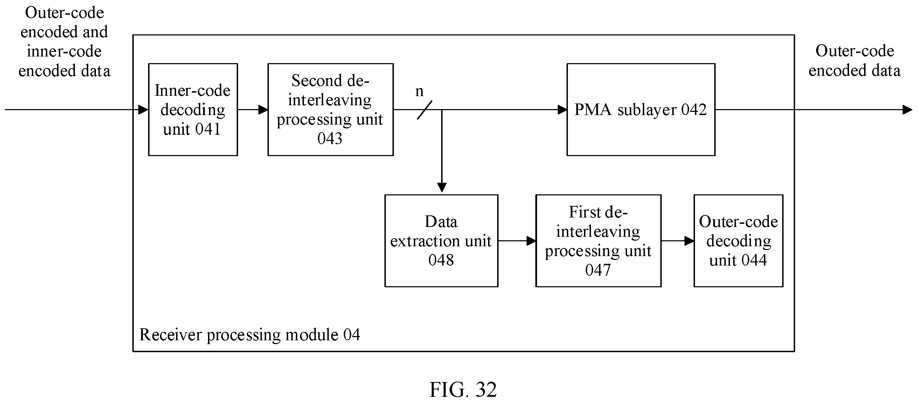

Optionally, specific implementations of outer-code decoded data vary with different application scenarios. In a case, as shown in FIG. 20, the outer-code decoded data may be inner-code decoded data. In another case, the outer-code decoded data may be data on which inner-code decoding and de-skewing are performed. For example, as shown in FIG. 22 and FIG. 23, after receiving the inner-code decoded data, the receiver processing module 04 may first perform de-skewing on the inner-code decoded data, and then perform outer-code decoding on de-skewed data. An alignment marker lock and lane de-skew unit 045 is disposed in the receiver processing module 04, and the alignment marker lock and lane de-skew unit 045 is configured to perform de-skewing on data. In yet another case, the outer-code decoded data may be data on which inner-code decoding, lane reordering, and first de-interleaving are performed. For example, as shown in FIG. 24, FIG. 25, and FIG. 26, after receiving the inner-code decoded data, the receiver processing module 04 may first perform lane reordering on the inner-code decoded data, perform first de-interleaving on lane-reordered data, and then perform outer-code decoding on data on which first de-interleaving is performed. A lane reordering unit 046 and a first de-interleaving processing unit 047 are disposed in the receiver processing module 04, the lane reordering unit 046 is configured to perform lane reordering on data, and the first de-interleaving processing unit 047 is configured to perform first de-interleaving on data. In still another case, when the outer-code encoded and inner-code encoded data is lane-reordered data, the outer-code decoded data may be data on which inner-code decoding and first de-interleaving are performed. In other words, the receiver processing module does not need to perform lane reordering on the outer-code encoded and inner-code encoded data. In this case, if the inner-code decoded data is data on which second interleaving is performed, the receiver processing module may first perform first de-interleaving on the inner-code decoded data, and then perform outer-code decoding on data on which first de-interleaving is performed. For example, as shown in FIG. 27 and FIG. 28, in yet another case, the outer-code decoded data may be data on which inner-code decoding and data extraction are performed. For example, as shown in FIG. 29 and FIG. 30, after receiving the inner-code decoded data, the receiver processing module 04 may first perform data extraction on the inner-code decoded data, and then perform outer-code decoding on data-extracted data. As shown in FIG. 29, FIG. 30, FIG. 31, and FIG. 32, a data extraction unit 048 is disposed in the receiver processing module 04, and the data extraction unit 048 is configured to perform data extraction on data. In still another case, the inner-code decoded data may be data on which data processing is performed, and the outer-code decoded data may be data on which inner-code decoding and inverse processing of the data processing are performed. Optionally, the data processing includes first interleaving, and the inverse processing includes second de-interleaving. For example, as shown in FIG. 28 to FIG. 32, after receiving the inner-code decoded data, the receiver processing module 04 may first perform second de-interleaving on the inner-code decoded data, and then perform outer-code decoding on data on which second de-interleaving is performed. In addition, when the data output by the receiver processing module is the data on which inner-code decoding and inverse processing of the data processing are performed, and the outer-code decoded data is the data on which inner-code decoding and inverse processing of the data processing are performed, the inverse processing may be performed after the receiver processing module receives the inner-code decoded data. After the inverse processing is performed, two types of processing may be performed on data on which inverse processing is performed. One type of processing is that the receiver processing module outputs the data, and the other type of processing is that the receiver processing module performs outer-code decoding. In this way, a process of performing outer-code decoding on the data and detecting the quality of the link does not affect the process of outputting the data by the receiver processing module, and does not additionally increase a transmission delay of data, to effectively reduce an overall transmission delay of the data.

For implementations of performing de-skewing on the data, performing lane reordering on the data, performing first de-interleaving on the data, performing data extraction on the data, and performing second de-interleaving on the data, refer to related descriptions in the foregoing content. Details are not described herein again. In addition, the outer-code decoded data may alternatively be data on which de-skewing, data extraction, lane reordering, and first de-interleaving are performed, and an execution sequence of a plurality of types of processing such as de-skewing, data extraction, lane reordering, and first de-interleaving may be adjusted depending on an application requirement.

Step 1904: The receiver processing module determines, based on the status of performing outer-code decoding on the inner-code decoded data, the quality of the link for transmission of the outer-code encoded and inner-code encoded data.

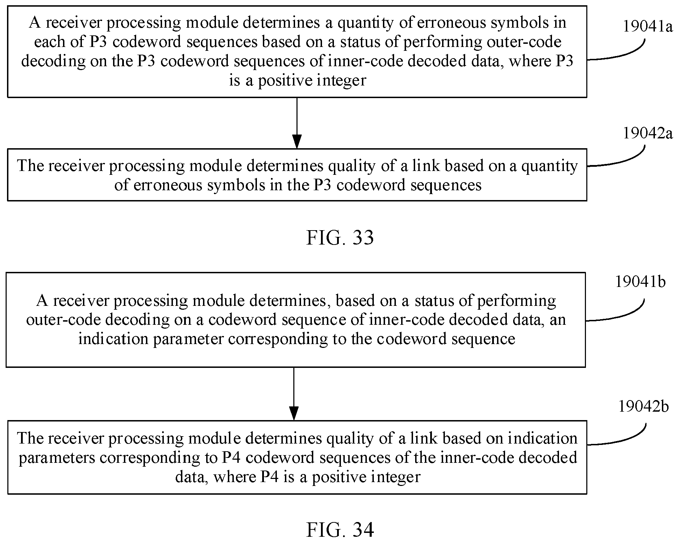

In an implementation, as shown in FIG. 33, an implementation process of step 1904 includes the following steps.

Step 19041a: The receiver processing module determines a quantity of erroneous symbols in each of P3 codeword sequences based on a status of performing outer-code decoding on the P3 codeword sequences of the inner-code decoded data, where P3 is a positive integer.

For an implementation process of step 19041a, refer to the implementation process of step 3041a.

Step 19042a: The receiver processing module determines the quality of the link based on a quantity of erroneous symbols in the P3 codeword sequences.

For an implementation process of step 19042a, refer to the implementation process of step 3042a.

In another implementation, as shown in FIG. 34, an implementation process of step 1904 includes the following steps.

Step 19041b: The receiver processing module determines, based on a status of performing outer-code decoding on a codeword sequence of the inner-code decoded data, an indication parameter corresponding to the codeword sequence.

For an implementation process of step 19041b, refer to the implementation process of step 3041b.

Step 19042b: The receiver processing module determines the quality of the link based on indication parameters corresponding to P4 codeword sequences of the inner-code decoded data, where P4 is a positive integer.

For an implementation process of step 19042b, refer to the implementation process of step 3042b.

In conclusion, in the link monitoring method, outer-code decoding is performed on the outer-code encoded data, and the quality of the link for transmission of the outer-code encoded data is determined based on the status of performing outer-code decoding on the outer-code encoded data. This can effectively monitor the quality of the link.

In addition, the inner-code decoded data needs to be output. In addition, outer-code decoding needs to be performed on the inner-code decoded data, and the quality of the link is determined based on the status of the outer-code decoding. The two processes are separately performed. Therefore, the process of performing outer-code decoding on the data and determining the quality of the link does not affect the process of outputting the inner-code decoded data, and does not additionally increase an overall transmission delay of data. Therefore, the link monitoring method can be applied to more transmission scenarios, and in particular, to a transmission scenario that has a low requirement on a transmission delay.

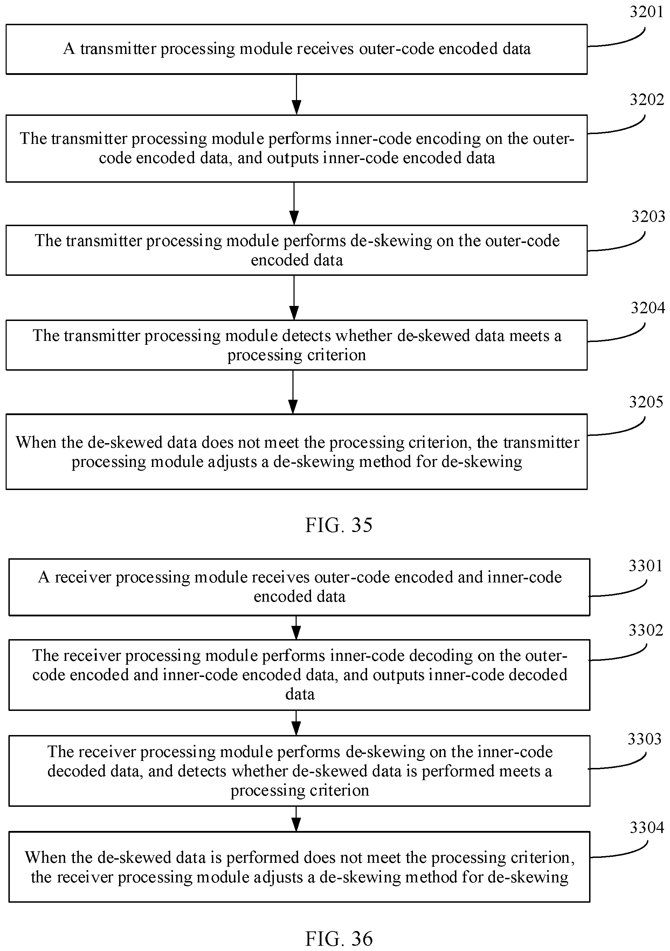

The following describes a link monitoring method applied to a transmitter processing module. The link monitoring method is used to monitor whether de-skewed data meets a processing criterion, and determine, based on a result of monitoring whether the data meets the processing criterion, a method for subsequent de-skewing. As shown in FIG. 35, an implementation process of the link monitoring method includes the following steps.

Step 3201: A transmitter processing module receives outer-code encoded data.

For an implementation process of step 3201, refer to the implementation process of step 301. Details are not described herein again.

Step 3202: The transmitter processing module performs inner-code encoding on the outer-code encoded data, and outputs inner-code encoded data.

For an implementation process in which the transmitter processing module performs inner-code encoding on the outer-code encoded data, refer to related descriptions in step 302. Details are not described herein again.

Optionally, before performing inner-code encoding on the outer-code encoded data, the transmitter processing module may perform data processing on the outer-code encoded data, and then perform inner-code encoding on data-processed data. In this case, an object (namely, data inner-code encoded by the transmitter processing module, which is also referred to as inner-code encoded data) on which inner-code encoding is performed by the transmitter processing module is data on which outer-code encoding and data processing are performed. In an implementation, as shown in FIG. 6, the data processing includes first interleaving.

In addition, before transmitting the inner-code encoded data to the channel transmission medium, the transmitter processing module may perform some data processing on the inner-code encoded data. For example, data processing such as modulation mapping or channel interleaving may be first performed on the inner-code encoded data, and data-processed data is transmitted to the channel transmission medium.

Step 3203: The transmitter processing module performs de-skewing on the outer-code encoded data.

Optionally, in different transmission scenarios, an execution occasion of the process in which the transmitter processing module performs de-skewing on the outer-code encoded data may be adjusted depending on requirements of a transmission scenario. In addition, during transmission, after receiving the outer-code encoded data, the transmitter processing module further needs to perform inner-code encoding on the outer-code encoded data, and outputs inner-code encoded data. The following describes, by using examples of different execution sequences between a process of performing de-skewing on the outer-code encoded data and a process in which the transmitter processing module performs inner-code encoding on the outer-code encoded data and outputs the inner-code encoded data, the execution occasion of the process of performing de-skewing on the outer-code encoded data.

In an implementation, as shown in FIG. 4, FIG. 6, FIG. 8, FIG. 9, FIG. 10, FIG. 11, FIG. 13, and FIG. 15, the process in which the transmitter processing module performs de-skewing on the outer-code encoded data may be performed before the process in which the transmitter processing module performs inner-code encoding on the outer-code encoded data and outputs the inner-code encoded data. In other words, an object (namely, inner-code encoded data) on which inner-code encoding is performed by the transmitter processing module is data on which outer-code encoding and de-skewing are performed. In this case, the process in which the transmitter processing module performs inner-code encoding on the outer-code encoded data includes: performing inner-code encoding on de-skewed data. It should be noted that, in some transmission scenarios, when the de-skewed data does not meet a processing criterion, the transmitter processing module also performs inner-code encoding on the data, and outputs inner-code encoded data. In some other transmission scenarios, when the de-skewed data does not meet the processing criterion, the transmitter processing module first modifies some data in the data, marks the data as data that does not meet the processing criterion, performs inner-code encoding, and outputs inner-code encoded data.

It should be noted that the de-skewed data usually includes a plurality of lanes of data. When the de-skewing process is performed before the process of inner-code encoding and outputting, after de-skewing and before inner-code encoding, the transmitter processing module may further perform lane reordering on the data, for example, as shown in FIG. 8, FIG. 9, FIG. 10, and FIG. 15.

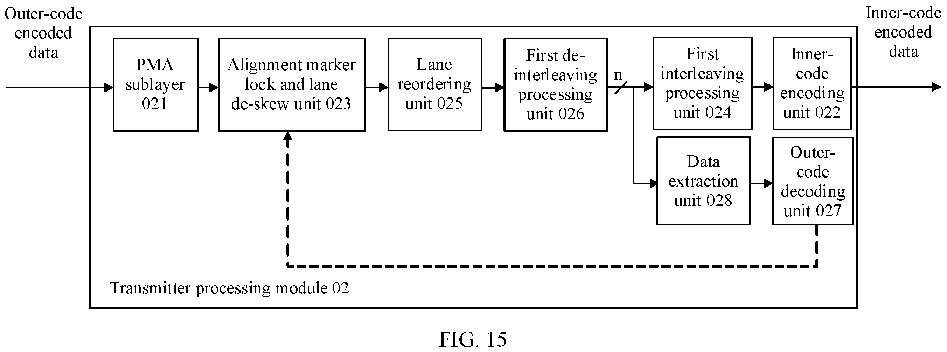

In addition, after performing lane reordering on the data, the transmitter processing module may further first perform first de-interleaving on the data. In other words, the inner-code encoded data is data on which outer-code encoding, de-skewing, lane reordering, and first de-interleaving are performed, for example, as shown in FIG. 9 and FIG. 15. In an implementation, the transmitter processing module may first perform lane reordering on de-skewed data, perform first de-interleaving on lane-reordered data, and then perform inner-code encoding on data on which first de-interleaving is performed. Alternatively, the transmitter processing module may first perform lane reordering on de-skewed data, perform first de-interleaving on lane-reordered data, perform first interleaving on data on which first de-interleaving is performed, and then perform inner-code encoding on data on which first interleaving is performed. For implementations of lane reordering and first de-interleaving, refer to related descriptions in the foregoing content. Details are not described herein again.

In another implementation, as shown in FIG. 5, FIG. 7, FIG. 12, and FIG. 14, on one hand, the transmitter processing module may perform de-skewing on the outer-code encoded data. On the other hand, the transmitter processing module may perform inner-code encoding on the outer-code encoded data and outputs the inner-code encoded data. In other words, the transmitter processing module performs de-skewing on the outer-code encoded data. In addition, the transmitter processing module performs inner-code encoding on the outer-code encoded data and outputs the inner-code encoded data. The two processes may be separately performed. In this case, after receiving the outer-code encoded data, the transmitter processing module performs two types of processing on the outer-code encoded data. One type of processing is performing de-skewing on the outer-code encoded data, and the other type of processing is performing inner-code encoding on the outer-code encoded data and outputting the inner-code encoded data. In this case, an object on which inner-code encoding is performed by the transmitter processing module is not the de-skewed data, but the received outer-code encoded data. In this way, the process of performing de-skewing on the outer-code encoded data does not affect the process of performing inner-code encoding on the outer-code encoded data and outputting the inner-code encoded data, and does not additionally increase an overall transmission delay of data, to further reduce an overall transmission delay of the data.

Step 3204: The transmitter processing module detects whether the de-skewed data meets the processing criterion.

On one hand, the transmitter processing module performs inner-code encoding on the outer-code encoded data, and outputs the inner-code encoded data. On the other hand, the transmitter processing module performs de-skewing on the outer-code encoded data, and detects whether the de-skewed data meets the processing criterion. In other words, the transmitter processing module performs inner-code encoding on the outer-code encoded data, and outputs the inner-code encoded data. In addition, the transmitter processing module detects whether the de-skewed data meets the processing criterion. The two processes are separately performed on two processing lanes. In this way, the process of detecting whether the de-skewed data meets the processing criterion does not affect the process of performing inner-code encoding on the outer-code encoded data and outputting the inner-code encoded data, and does not additionally increase an overall transmission delay of data, to effectively reduce an overall transmission delay of the data.

In an implementation, the transmitter processing module may determine, based on a status of performing outer-code decoding on the de-skewed data, whether the de-skewed data meets the processing criterion. Correspondingly, that the transmitter processing module detects whether the de-skewed data meets the processing criterion includes: The transmitter processing module performs outer-code decoding on the de-skewed data, and determines, based on the status of the outer-code decoding, whether the de-skewed data meets the processing criterion. As shown in FIG. 4 to FIG. 15, the outer-code decoding unit 027 is disposed in the transmitter processing module 02, and the outer-code decoding unit 027 is configured to perform outer-code decoding on the de-skewed data, and determine, based on the status of the outer-code decoding, whether the de-skewed data meets the processing criterion. In FIG. 4 to FIG. 15, an arrow pointing from the outer-code decoding unit 027 to the alignment marker lock and lane de-skew unit 023 indicates whether the de-skewed data meets the processing criterion.

Optionally, when determining that the de-skewed data can be successfully decoded, the transmitter processing module may determine that the de-skewed data meets the processing criterion. There are a plurality of implementations for determining whether the de-skewed data can be successfully decoded. In this embodiment of this application, the following two implementations are used as examples for description.

In an implementation, after the process of decoding the de-skewed data is completed, the transmitter processing module determines that the de-skewed data can be successfully decoded. In other words, the transmitter processing module may perform a complete decoding process on the de-skewed data. After the complete decoding process is performed on the de-skewed data, if it is determined that the process of decoding the de-skewed data is completed, the transmitter processing module determines that the de-skewed data can be successfully decoded. For example, when outer code is Reed-Solomon code, the transmitter processing module may calculate a syndrome (syndrome) for a received codeword sequence of the de-skewed data; calculate an error locator polynomial (error locator polynomial) based on the syndrome and solve a key equation (key equation), to obtain an error location in which a code error occurs; and then determine an error value of the code error based on the error location, to decode a codeword, so as to decode the de-skewed data.

For de-skewed data that includes a plurality of codeword sequences, if it is found in the decoding process that N1 consecutive codeword sequences of the de-skewed data fail to be decoded, it may be determined that the de-skewed data cannot be successfully decoded. Correspondingly, it may be determined the de-skewed data does not meet the processing criterion. N1 is a positive integer greater than 1, and a value of N1 may be adjusted depending on an application scenario. For example, when outer code is RS code, and KP4 RS (544, 514) code is used for the RS code, the value of N1 may be 3. It should be noted that, when a codeword data stream received by a decoder may be divided into q codeword data streams, and q sub-decoders are used for decoding, the "N1 consecutive codeword sequences of the de-skewed data fail to be decoded" may be that N1 consecutive codeword sequences in any codeword data stream fail to be decoded. q is a positive integer greater than 1. In other words, for the de-skewed data that includes a plurality of codeword sequences, when the data may be divided into the q codeword data streams, and the q sub-decoders are used to for decoding, if it is found in the decoding process that N1 consecutive codeword sequences in any data stream fail to be decoded, it may be determined that the de-skewed data does not meet the processing criterion.

Alternatively, for the de-skewed data that includes one or more sets including M1 codeword sequences, if N2 consecutive codeword sequences in any M1 codeword sequences fail to be decoded, it may be determined that the de-skewed data cannot be successfully decoded. Correspondingly, it may be determined the de-skewed data does not meet the processing criterion. N2 is a positive integer greater than 1, M1 is a positive integer greater than N2, and values of M1 and N2 may be adjusted depending on an application scenario.

It should be noted that, in the foregoing descriptions, "N1 consecutive codeword sequences of the de-skewed data fail to be decoded" and "N2 consecutive codeword sequences in M1 codeword sequences fail to be decoded" mean that the decoder detects that a corresponding quantity of codeword sequences fail to be decoded.

In another implementation, a syndrome may be calculated for each codeword sequence of the de-skewed data. When the syndrome of the codeword sequence of the de-skewed data indicates that the de-skewed data can be successfully decoded, the transmitter processing module determines that the de-skewed data can be successfully decoded. The syndrome of the codeword sequence can directly indicate whether the codeword sequence can be successfully decoded. In addition, when whether the codeword sequence can be successfully decoded is directly determined based on the syndrome, for the de-skewed data that includes a plurality of codeword sequences, if it is determined based on the syndrome that N1 consecutive codeword sequences of the de-skewed data cannot be successfully decoded, it may be determined that the codeword stream cannot be successfully decoded. Alternatively, for the de-skewed data that includes one or more sets including M1 codeword sequences, if it is determined, based on the syndrome, that N2 consecutive codeword sequences in any M1 codeword sequences of the de-skewed data fail to be decoded, it may be determined that the codeword stream cannot be successfully decoded.

Whether the de-skewed data can be successfully decoded is determined based on the syndrome of the codeword sequence of the de-skewed data. Therefore, a complete decoding process does not need to be performed on the de-skewed data, to reduce power consumption and calculation complexity of the transmitter processing module.

Optionally, the data that is detected whether the processing criterion is met may alternatively be data on which some processing and de-skewing are performed. In addition, processing performed on the data may vary with different transmission scenarios. In this embodiment of this application, the following cases are used as examples for description.

In a first case, the data (namely, the de-skewed data) that is detected whether the processing criterion is met may be data on which de-skewing and data extraction are performed, for example, as shown in FIG. 13 to FIG. 15.

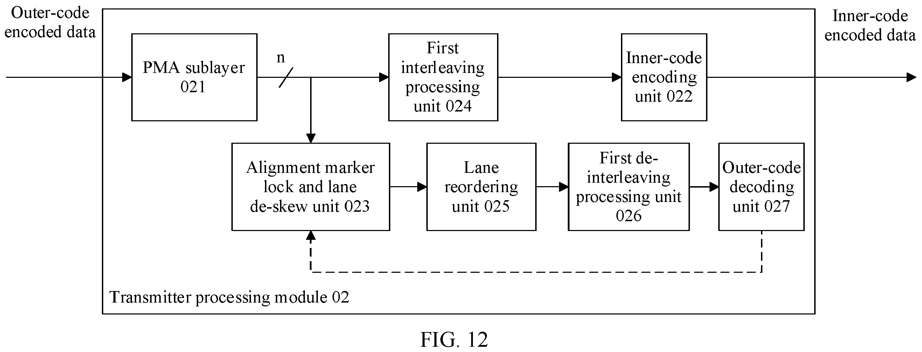

In a second case, it can be learned from the foregoing descriptions that the data that is detected whether the processing criterion is met may be data on which de-skewing, lane reordering, and first de-interleaving are performed, for example, as shown in FIG. 9, FIG. 10, FIG. 11, FIG. 12, FIG. 13, FIG. 14, and FIG. 15. In addition, when the de-skewing is performed before inner-code encoding and outputting, the lane reordering and the first de-interleaving may be performed after the de-skewing and before the inner-code encoding, for example, as shown in FIG. 9 and FIG. 15. When the de-skewing process and the process of inner-code encoding and outputting are separately performed, the lane reordering and the first de-interleaving may be performed after the de-skewing, for example, as shown in FIG. 12, FIG. 13, and FIG. 14.

In a third case, the data that is detected whether the processing criterion is met may be data on which de-skewing, data extraction, lane reordering, and first de-interleaving are performed. An execution sequence of a plurality of types of processing such as de-skewing, data extraction, lane reordering, and first de-interleaving may be adjusted depending on an application requirement. For example, data extraction may be first performed on the data, then lane reordering is performed on data-extracted data, and then first de-interleaving is performed on lane-reordered data. Alternatively, lane reordering may first be performed on the data, first de-interleaving is performed on lane-reordered data, and then data extraction is performed on data on which first de-interleaving is performed. This is not specifically limited in this embodiment of this application. In addition, an execution sequence of a process of data extraction and a process of performing de-skewing on data may also be adjusted depending on an application requirement. For example, based on the foregoing descriptions, de-skewing may first be performed on data, and then data extraction is performed on de-skewed data; or data extraction may first be performed on data, and then de-skewing is performed on data-extracted data. This is also not specifically limited in this embodiment of this application.

Step 3205: When the de-skewed data does not meet the processing criterion, the transmitter processing module adjusts a de-skewing method for de-skewing.

When the de-skewed data does not meet the processing criterion, it indicates that the de-skewing performed on the outer-code encoded data does not meet a de-skewing requirement. In this case, the transmitter processing module needs to adjust the de-skewing method for de-skewing, to perform effective de-skewing on the data. When the de-skewed data meets the processing criterion, the de-skewing method does not need to be adjusted. In an implementation, de-skewing performed on the data may be implemented by using a state machine, and adjusting the de-skewing method for de-skewing may be implemented by restarting (restart) the state machine.

In conclusion, in the link monitoring method, inner-code encoding needs to be performed on the outer-code encoded data, and inner-code encoded data is output. In addition, whether the de-skewed data meets the processing criterion needs to be detected. The two processes are separately performed. Therefore, the process of detecting whether the de-skewed data meets the processing criterion does not affect the process of performing inner-code encoding on the data and outputting the data, and does not additionally increase an overall transmission delay of data. Therefore, the link monitoring method can be applied to more transmission scenarios, and in particular, to a transmission scenario that has a low requirement on a transmission delay.

The following describes a link monitoring method applied to a receiver processing module. The link monitoring method is used to monitor whether de-skewed data meets a processing criterion, and determine, based on a result of monitoring whether the data meets the processing criterion, a method for subsequent de-skewing. As shown in FIG. 36, an implementation process of the link monitoring method includes the following steps.

Step 3301: A receiver processing module receives outer-code encoded and inner-code encoded data.

For an implementation process of step 3301, refer to the implementation process of step 1901.

Step 3302: The receiver processing module performs inner-code decoding on the outer-code encoded and inner-code encoded data, and outputs inner-code decoded data.

For an implementation process of step 3302, refer to the implementation process of step 1902.

Step 3303: The receiver processing module performs de-skewing on the inner-code decoded data, and detects whether de-skewed data meets a processing criterion.

For an implementation process in which the receiver processing module performs de-skewing on the inner-code decoded data, refer to the implementation process in which the transmitter processing module performs de-skewing on the outer-code encoded data. Details are not described herein again.

For an implementation process in which the receiver processing module detects whether the de-skewed data meets the processing criterion, refer to the implementation process in which the transmitter processing module detects whether the de-skewed data meets the processing criterion. For example, the receiver processing module may perform outer-code decoding on the de-skewed data, and determine, based on a status of the outer-code decoding, whether the de-skewed data meets the processing criterion. Optionally, when the de-skewed data can be successfully decoded, it may be determined that the de-skewed data meets the processing criterion. In addition, after a process of decoding the de-skewed data is completed, the receiver processing module may determine that the de-skewed data can be successfully decoded. Alternatively, when a syndrome of a codeword sequence of the de-skewed data indicates that the de-skewed data can be successfully decoded, the receiver processing module may determine that the de-skewed data can be successfully decoded. Further, when N3 consecutive codeword sequences of the de-skewed data fail to be decoded, it may be determined that the de-skewed data does not meet the processing criterion. N3 is a positive integer greater than 1. Alternatively, if the de-skewed data includes M2 codeword sequences, when N4 codeword sequences in M2 codeword sequences fail to be decoded, the de-skewed data does not meet the processing criterion. N4 is a positive integer greater than 1, and M2 is a positive integer greater than N4.

As shown in FIG. 22 to FIG. 30, the outer-code decoding unit 044 and the alignment marker lock and lane de-skew unit 045 are disposed in the receiver processing module 04. The alignment marker lock and lane de-skew unit 045 is configured to perform de-skewing on a signal. The outer-code decoding unit 044 is configured to perform outer-code decoding on the de-skewed data, and determine, based on the status of the outer-code decoding, whether the de-skewed data meets the processing criterion. In FIG. 22 to FIG. 30, an arrow pointing from the outer-code decoding unit 044 to the alignment marker lock and lane de-skew unit 045 indicates whether the de-skewed data meets the processing criterion.

On one hand, the receiver processing module outputs the inner-code decoded data. On the other hand, the receiver processing module performs de-skewing on the inner-code decoded data, and detects whether the de-skewed data meets the processing criterion. In other words, the receiver processing module outputs the inner-code decoded data. In addition, the receiver processing module detects whether the de-skewed data meets the processing criterion. The two processes are separately performed on two processing lanes. In this way, the process of detecting whether the de-skewed data meets the processing criterion does not affect the process of outputting the inner-code decoded data, and does not additionally increase an overall transmission delay of data, to effectively reduce an overall transmission delay of the data.

Optionally, the outer-code encoded and inner-code encoded data may be data on which data processing is performed. Correspondingly, the inner-code decoded data may be the data on which data processing is performed. The de-skewed data may be data on which inner-code decoding and inverse processing of the data processing are performed. In an implementation, the data processing includes first interleaving, and the inverse processing includes second de-interleaving. In this case, that the receiver processing module performs de-skewing on the inner-code decoded data includes: The receiver processing module performs the inverse processing of the data processing on the inner-code decoded data, and performs de-skewing on data on which inverse processing is performed, as shown in FIG. 21, FIG. 23, FIG. 25, FIG. 28, FIG. 29, and FIG. 30. When the receiver processing module needs to perform inverse processing on the inner-code decoded data before outputting the data, and needs to perform inverse processing on the data before performing de-skewing on the data, the inverse processing may be performed after the receiver processing module performs inner-code decoding on the outer-code encoded and inner-code encoded data. After the inverse processing is performed, two types of processing are performed on the data on which inverse processing is performed. One type of processing is that the receiver processing module outputs the data, and the other type of processing is that the receiver processing module performs de-skewing on the data. In this way, because de-skewing is not performed on a transmission path for outputting the inner-code decoded data, the process of de-skewing and detecting whether the processing criterion is met does not affect the process of outputting the inner-code decoded data, and does not additionally increase an overall transmission delay of data, to effectively reduce an overall transmission delay of the data.

It should be noted that the data (namely, the de-skewed data) that is detected whether the processing criterion is met may alternatively be data on which some processing and de-skewing are performed. For example, the de-skewed data may be data on which de-skewing and data extraction are performed. In this case, that the receiver processing module detects whether the de-skewed data meets the processing criterion includes: The receiver processing module performs data extraction on the de-skewed data, and detects whether data-extracted data meets the processing criterion. In an implementation, as shown in FIG. 29 and FIG. 30, the data extraction unit 048 is disposed in the receiver processing module 04, and the data extraction unit 048 is configured to perform data extraction on data. For an implementation of data extraction, refer to related descriptions in the foregoing content.

For another example, if the de-skewed data includes a plurality of lanes of data, the de-skewed data may be data on which de-skewing, lane reordering, and first de-interleaving are performed. In this case, that the receiver processing module detects whether the de-skewed data meets the processing criterion includes: The receiver processing module performs lane reordering on de-skewed data of a plurality of lanes, performs first de-interleaving on lane-reordered data, and detects whether data on which first de-interleaving is performed meets the processing criterion, as shown in FIG. 24, FIG. 25, and FIG. 29. For implementation processes of lane reordering and first de-interleaving, refer to related descriptions in the foregoing content.

For another example, the de-skewed data may alternatively be data on which de-skewing, data extraction, lane reordering, and first de-interleaving are performed. An execution sequence of a plurality of types of processing such as de-skewing, data extraction, lane reordering, and first de-interleaving may be adjusted depending on an application requirement. For example, data extraction may be first performed on the data, and then lane reordering and first de-interleaving are performed on data-extracted data. Alternatively, lane reordering and first de-interleaving may first be performed on the data, and then data extraction is performed on data on which lane reordering and first de-interleaving are performed. This is not specifically limited in this embodiment of this application. In addition, an execution sequence of a process of data extraction and a process of performing de-skewing on data may also be adjusted depending on an application requirement. For example, based on the foregoing descriptions, de-skewing may first be performed on data, and then data extraction is performed on de-skewed data. Alternatively, data extraction may first be performed on data, and then de-skewing is performed on data-extracted data. This is also not specifically limited in this embodiment of this application.

Step 3304: When the de-skewed data does not meet the processing criterion, the receiver processing module adjusts a de-skewing method for de-skewing.

In conclusion, in the link monitoring method, the inner-code decoded data needs to be output. In addition, whether the de-skewed data meets the processing criterion needs to be detected. The two processes are separately performed. Therefore, the process of detecting whether the de-skewed data meets the processing criterion does not affect the process of outputting the inner-code decoded data, and does not additionally increase a transmission delay of data. Therefore, the link monitoring method can be applied to more transmission scenarios, and in particular, to a transmission scenario that has a low requirement on a transmission delay.

The link monitoring method provided in this embodiment of this application is applicable to a plurality of data center interconnect (data center interconnect, DCI) application scenarios.

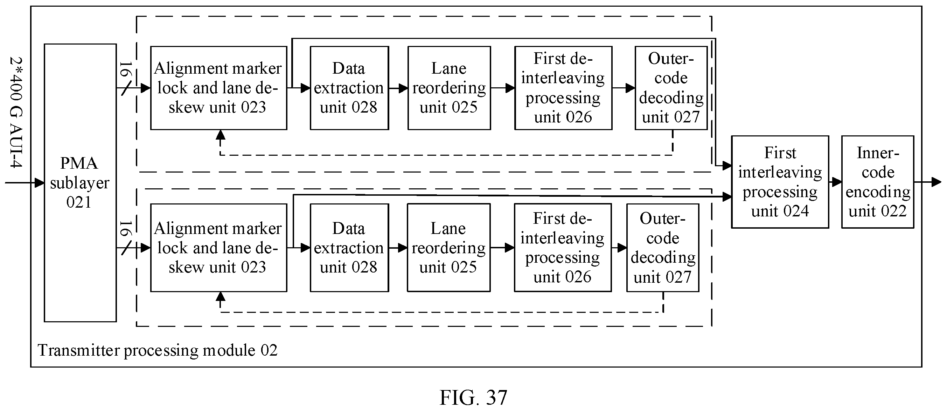

For example, FIG. 37 shows an application scenario in which a link monitoring method is applicable to a transmitter processing module with a coherent line interface of an 800 G single-wavelength and a transmitter device with a 2*400 G interface according to an embodiment of this application. In this case, the transmitter device may transmit data to the transmitter processing module through eight synchronous physical lanes (every four physical lanes belong to one 400G AUI-4 interface) of an AUI. After a PMA sublayer of the transmitter processing module demultiplexes the data, 32 PCSL data streams may be obtained. The 32 PCSL data streams may be grouped into two data streams, and each data stream includes 16 PCSL data streams. The transmitter processing module may separately perform de-skewing on the two data streams, and detect whether de-skewed data meets a processing criterion, to determine, based on a result of whether the de-skewed data meets the processing criterion, a de-skewing method used by the transmitter processing module for de-skewing. In addition, the transmitter processing module may perform first interleaving on the two data streams on which de-skewing is performed, perform inner-code encoding on data on which first interleaving is performed, and output inner-code encoded data.

It should be noted that, in some scenarios, the transmitter processing module groups the 32 PCSL data streams into two data streams, performs alignment marker locking on 16 PCSL data streams based on alignment markers of the 16 PCSL data streams in each data stream, and determines whether the alignment markers of the 16 PCSL data streams are valid. Then, after it is determined that alignment markers of the 32 PCSL data streams in the two data streams are valid, de-skewing is performed on the 32 PCSL data streams based on the alignment markers of the 32 PCSL data streams. Then, whether the two data streams on which de-skewing is performed meet the processing criterion is separately detected.

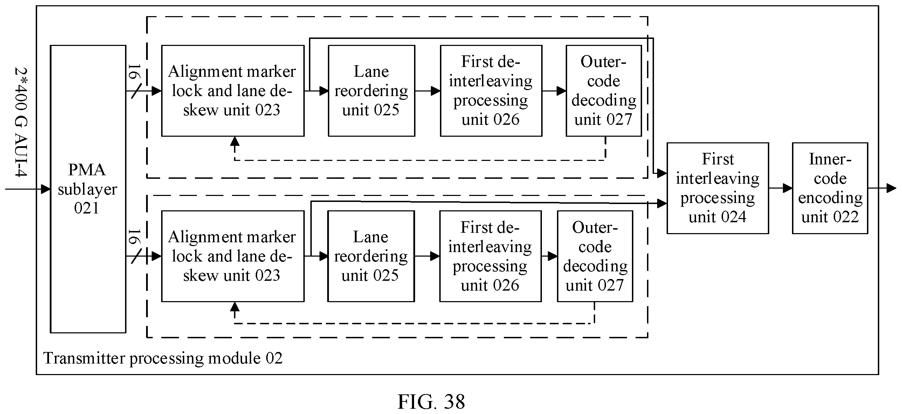

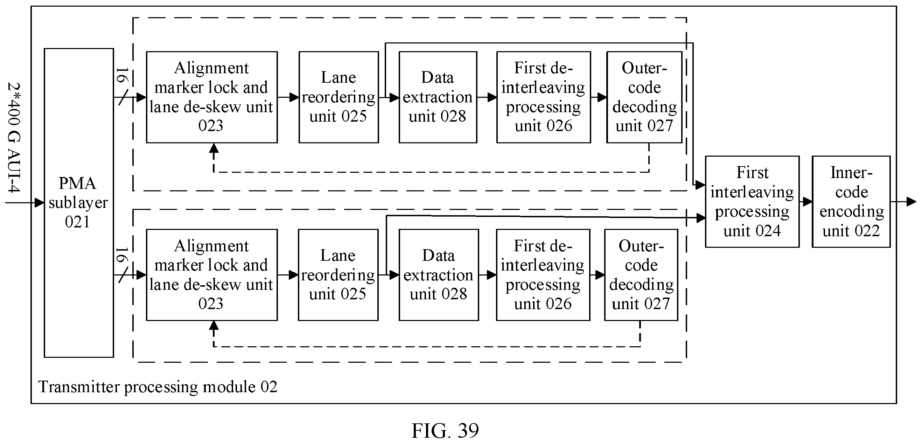

The transmitter processing module may perform outer-code decoding on the de-skewed data, to detect whether the de-skewed data meets the processing criterion. After performing de-skewing on the data, the transmitter processing module may further sequentially perform data extraction, lane reordering, and first de-interleaving on the de-skewed data, and then perform outer-code decoding on data on which first de-interleaving is performed. In addition, the transmitter processing module may further determine, based on a status of performing outer-code decoding on the data, quality of a link, namely, quality of the AUI, for transmitting data to the transmitter processing module. As shown in FIG. 37, each dashed-line box in FIG. 37 indicates processing of one data stream. In addition, because the transmitter processing module groups the 32 PCSL data streams into two data streams for processing, if the processing includes performing data extraction on the data stream, and T used for data extraction is greater than T0, a throughput rate for processing each data stream may be T0/(2xT) of a throughput rate before inner-code encoding is performed on the data on which first interleaving is performed. Optionally, as shown in FIG. 38, the transmitter processing module may not perform data extraction on the data. In addition, as shown in FIG. 39, a process of performing lane reordering on the data may be performed between performing de-skewing on the data and performing inner-code encoding on the data. FIG. 39 shows that de-skewing is first performed on the data, and then lane reordering is performed on the data. Then, two types of processing are performed on lane-reordered data. One type of processing is sequentially performing first interleaving and inner-code encoding on the lane-reordered data, and the other type of processing is sequentially performing data extraction, first de-interleaving, and outer-code decoding on the lane-reordered data. In addition, in this process, whether to perform data extraction on the data may alternatively be selected depending on an application requirement.

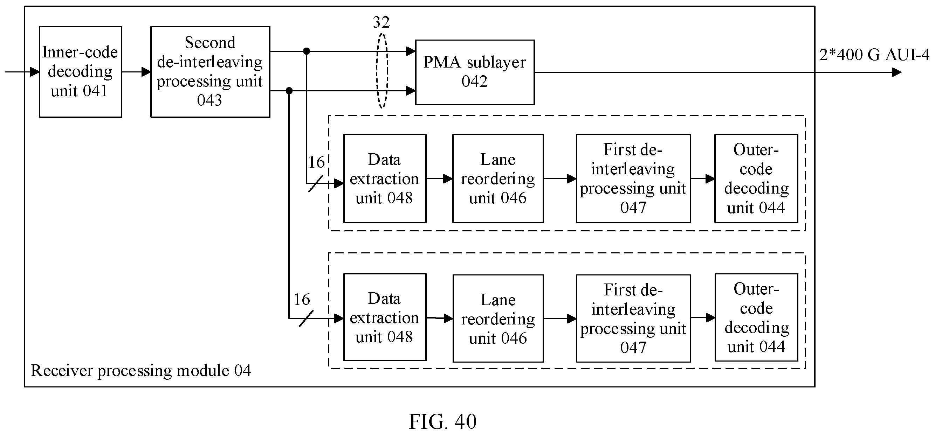

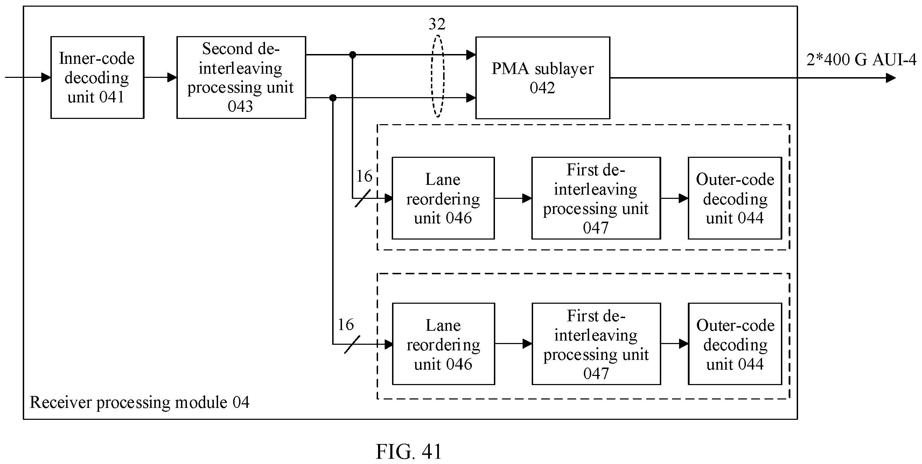

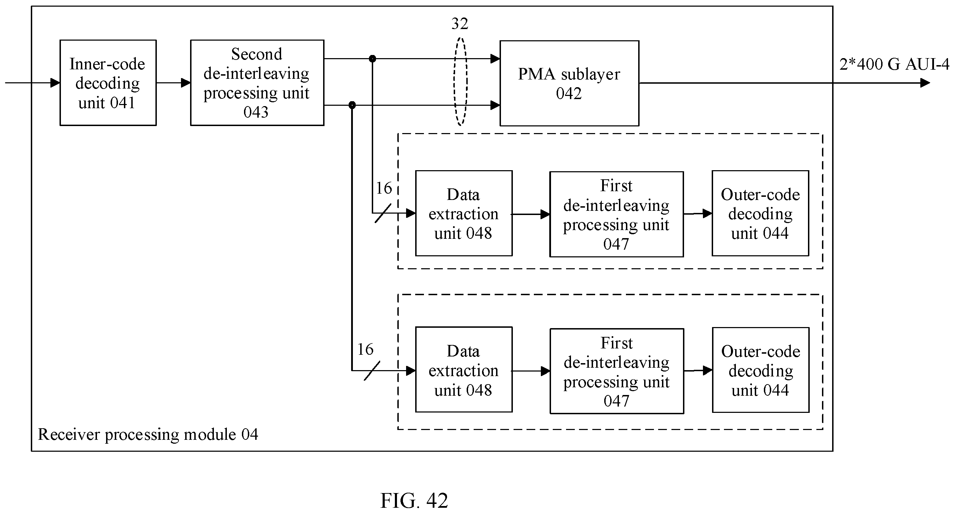

Similarly, in this application scenario, as shown in FIG. 40, after receiving data, a receiver processing module performs second de-interleaving on the data, to obtain 32 PCSL data streams. On one hand, the receiver processing module outputs the 32 PCSL data streams by using the PMA sublayer. On the other hand, the receiver processing module groups the 32 PCSL data streams into two data streams, where each data stream includes 16 PCSL data streams; performs outer-code decoding on each data stream; and determines quality of a link, namely, quality of an optical fiber link, based on a status of the outer-code decoding. In addition, before performing outer-code decoding on the data stream, the transmitter processing module may further sequentially perform data extraction, lane reordering, and first de-interleaving on the data. Optionally, as shown in FIG. 41, the receiver processing module may not perform data extraction on the data. In addition, when lane reordering is performed between de-skewing and inner-code encoding, as shown in FIG. 42, the receiver processing module does not need to perform lane reordering on the data stream. In addition, in this process, whether to perform data extraction on the data may also be selected depending on an application requirement.

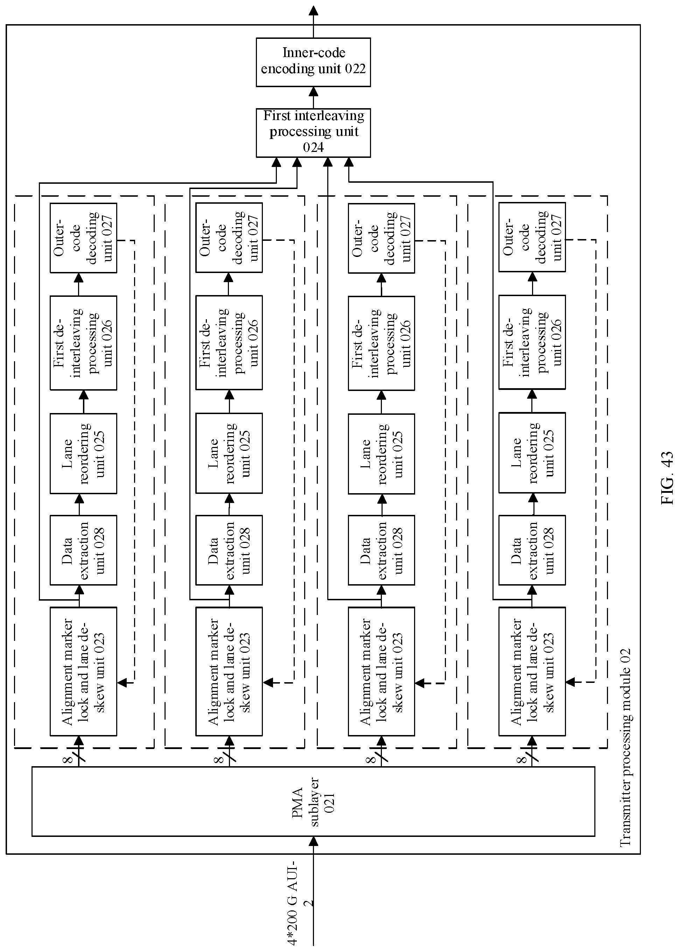

For another example, FIG. 43 shows an application scenario in which a link monitoring method is applicable to a transmitter processing module with a coherent line interface of an 800 G single-wavelength and a transmitter device with a 4*200 G interface according to an embodiment of this application. In this case, the transmitter device may transmit data to the transmitter processing module through eight synchronous physical lanes (every two physical lanes belong to one 200G AUI-2 interface) of an AUI. After a PMA sublayer of the transmitter processing module demultiplexes the data, 32 PCSL data streams may be obtained. The 32 PCSL data streams may be grouped into four data streams, and each data stream includes eight PCSL data streams. The transmitter processing module may separately perform de-skewing on the four data streams, and detect whether de-skewed data meets a processing criterion, to determine, based on a result of whether the de-skewed data meets the processing criterion, a de-skewing method used by the transmitter processing module for de-skewing. In addition, the transmitter processing module may perform first interleaving on the four data streams on which de-skewing is performed, perform inner-code encoding on data on which first interleaving is performed, and output inner-code encoded data.

It should be noted that, in some scenarios, the transmitter processing module groups the 32 PCSL data streams into four data streams, performs alignment marker locking on eight PCSL data streams based on alignment markers of the eight PCSL data streams in each data stream, and determines whether the alignment markers of the eight PCSL data streams are valid. Then, after it is determined that alignment markers of the 32 PCSL data streams in the four data streams are valid, de-skewing is performed on the 32 PCSL data streams based on the alignment markers of the 32 PCSL data streams. Then, whether the four data streams on which de-skewing is performed meet the processing criterion is separately detected.

The transmitter processing module may perform outer-code decoding on the de-skewed data, to detect whether the de-skewed data meets the processing criterion. After performing de-skewing on the data, the transmitter processing module may further sequentially perform data extraction, lane reordering, and first de-interleaving on the de-skewed data, and then perform outer-code decoding on data on which first de-interleaving is performed. In addition, the transmitter processing module may further determine, based on a status of performing outer-code decoding on the data, quality of a link, namely, quality of the AUI, for transmitting data to the transmitter processing module. As shown in FIG. 43, each dashed-line box in FIG. 43 indicates processing of one data stream. In addition, because the transmitter processing module groups the 32 PCSL data streams into four data streams for processing, if the processing includes performing data extraction on the data stream, and T used for data extraction is greater than T0, a throughput rate for processing each data stream may be T0/(4xT) of a throughput rate before inner-code encoding is performed on the data on which first interleaving is performed.

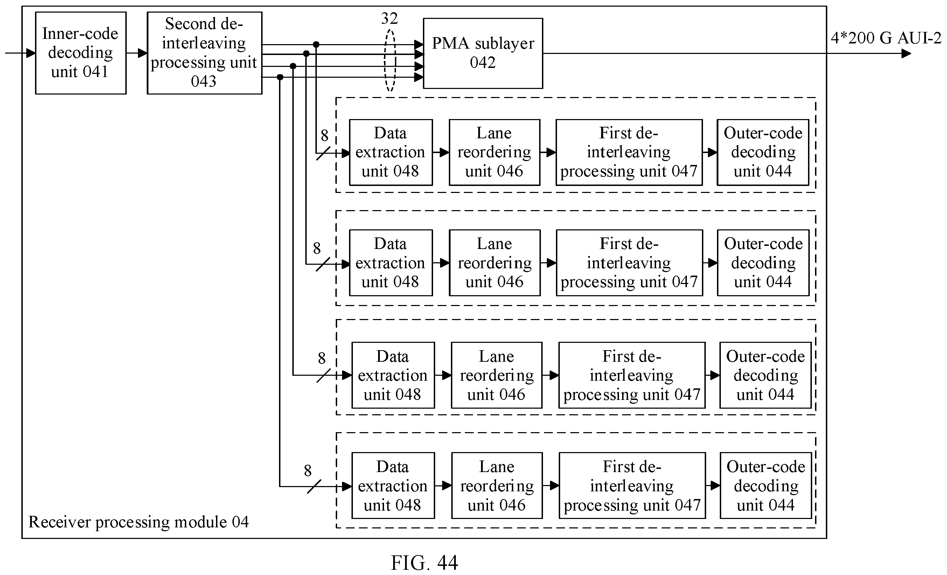

Similarly, in this application scenario, as shown in FIG. 44, after receiving the data, a receiver processing module performs second de-interleaving on the data, to obtain 32 PCSL data streams. On one hand, the receiver processing module outputs the 32 PCSL data streams by using the PMA sublayer. On the other hand, the receiver processing module also groups the 32 PCSL data streams into four data streams, where each data stream includes eight PCSL data streams; performs outer-code decoding on each data stream; and determines quality of a link, namely, quality of an optical fiber link, based on a status of the outer-code decoding. In addition, before performing outer-code decoding on the data stream, the transmitter processing module may further sequentially perform data extraction, lane reordering, and first de-interleaving on the data.

For another example, FIG. 13 shows an application scenario in which a link monitoring method is applicable to a transmitter processing module with a coherent line interface of an 800 G single-wavelength and a transmitter device with a 1 *800 G interface according to an embodiment of this application. In this case, the transmitter device may transmit data to the transmitter processing module through eight synchronous physical lanes of an AUI, where the eight physical lanes belong to one 800 G AUI-8 interface. After a PMA sublayer of the transmitter processing module demultiplexes the data, 32 (that is, n=32 in FIG. 13) PCSL data streams may be obtained. The 32 PCSL data streams are used as one data stream (including 32 PCSL data streams). The transmitter processing module may perform de-skewing on the one data stream, and detect whether de-skewed data meets a processing criterion, to determine, based on a result of whether the de-skewed data meets the processing criterion, a de-skewing method used by the transmitter processing module for de-skewing. In addition, the transmitter processing module may perform first interleaving on the one data stream on which de-skewing is performed, perform inner-code encoding on data on which first interleaving is performed, and output inner-code encoded data. The transmitter processing module may perform outer-code decoding on the de-skewed data, to detect whether the de-skewed data meets the processing criterion. After performing de-skewing on the data, the transmitter processing module may further sequentially perform data extraction, lane reordering, and first de-interleaving on the de-skewed data, and then perform outer-code decoding on data on which first de-interleaving is performed. In addition, the transmitter processing module may further determine, based on a status of performing outer-code decoding on the data, quality of a link, namely, quality of the AUI, for transmitting data to the transmitter processing module. As shown in FIG. 13, a dashed-line box in FIG. 13 indicates processing of one data stream. In addition, because the transmitter processing module uses the 32 PCSL data streams as one data stream for processing, if the processing includes performing data extraction on the data stream, and T used for data extraction is greater than T0, a throughput rate for processing each data stream may be T0/T of a throughput rate before inner-code encoding is performed on the data on which first interleaving is performed.

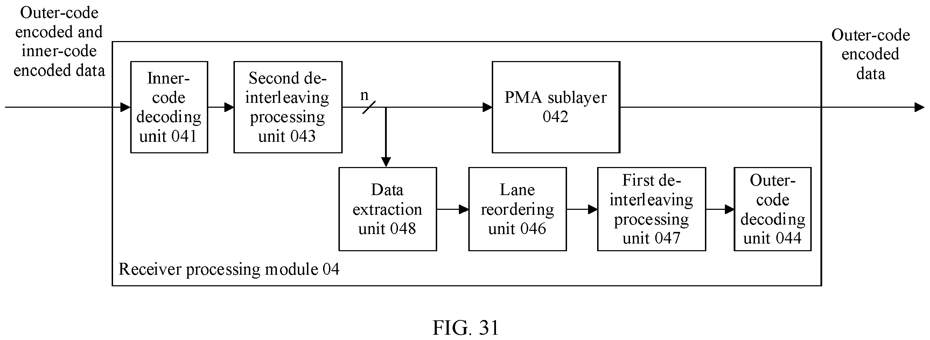

Similarly, in this application scenario, as shown in FIG. 31, after receiving the data, the receiver processing module performs de-interleaving on the data, to obtain 32 (that is, n=32 in FIG. 31) PCSL data streams. On one hand, the receiver processing module outputs the 32 PCSL data streams by using the PMA sublayer. On the other hand, the receiver processing module also uses the 32 PCSL data streams as one data stream, performs outer-code decoding on the one data stream, and determines quality of a link, namely, quality of an optical fiber link, based on a status of the outer-code decoding. In addition, before performing outer-code decoding on the data stream, the transmitter processing module may sequentially perform data extraction, lane reordering, and first de-interleaving on the data.

For another example, FIG. 13 shows an application scenario in which a link monitoring method is applicable to a transmitter processing module with a coherent line interface of a 400 G single-wavelength and a transmitter device with a 1 *400 G interface according to an embodiment of this application is applicable. In this case, the transmitter device may transmit data to the transmitter processing module through eight synchronous physical lanes of an AUI, where the eight physical lanes belong to one 400 G AUI-8 interface. After a PMA sublayer of the transmitter processing module demultiplexes the data, 16 (that is, n=16 in FIG. 13) PCSL data streams may be obtained. The 16 PCSL data streams may be used as one data stream. The transmitter processing module may perform de-skewing on the one data stream, and detect whether de-skewed data meets a processing criterion, to determine, based on a result of whether the de-skewed data meets the processing criterion, a de-skewing method used by the transmitter processing module for de-skewing. In addition, the transmitter processing module may perform first interleaving on the one data stream on which de-skewing is performed, perform inner-code encoding on data on which first interleaving is performed, and output inner-code encoded data. The transmitter processing module may perform outer-code decoding on the de-skewed data, to detect whether the de-skewed data meets the processing criterion. After performing de-skewing on the data, the transmitter processing module may further sequentially perform data extraction, lane reordering, and first de-interleaving on the de-skewed data, and then perform outer-code decoding on data-extracted data. In addition, the transmitter processing module may further determine, based on a status of performing outer-code decoding on the data, quality of a link, namely, quality of the AUI, for transmitting data to the transmitter processing module. As shown in FIG. 13, a dashed-line box in FIG. 13 indicates processing of one data stream. In addition, because the transmitter processing module uses the 16 PCSL data streams as one data stream for processing, if the processing includes performing data extraction on the data stream, and T used for data extraction is greater than T0, a throughput rate for processing each data stream may be T0/T of a throughput rate before inner-code encoding is performed on the data on which first interleaving is performed.

Similarly, in this application scenario, as shown in FIG. 31, after receiving the data, the receiver processing module performs second de-interleaving on the data, to obtain 16 (that is, n=16 in FIG. 31) PCSL data streams. On one hand, the receiver processing module outputs the 16 PCSL data streams by using the PMA sublayer. On the other hand, the receiver processing module also uses the 16 PCSL data streams as one data stream, performs outer-code decoding on the one data stream, and determines quality of a link, namely, quality of an optical fiber link, based on a status of the outer-code decoding. In addition, before performing outer-code decoding on the data stream, the transmitter processing module may sequentially perform data extraction, lane reordering, and first de-interleaving on the data.

In addition to the foregoing example application scenarios, the link monitoring method provided in embodiments of this application is further applicable to another application scenario, for example, is applicable to another transmission scenario with a higher speed such as 400 G, 600 G, 800 G, or even 1.6 T or 3.2 T. In this case, an example in which the link monitoring method is applicable to a speed of 800 G or 1.6 T is used. The link monitoring method may further be applied to another transmitter processing module provided in embodiments of this application. A transmitter device may transmit data to the transmitter processing module through an 800 G AUI-m/1600 G AUI-m interface including m physical lanes. After a PMA sublayer of the transmitter processing module demultiplexes the data, n PCSL data streams may be obtained. Then, de-skewing is performed on the n PCSL data streams, and whether de-skewed data meets a processing criterion is detected, to determine, based on a result of whether the de-skewed data meets the processing criterion, a de-skewing method used by the transmitter processing module for de-skewing. In addition, first interleaving is performed on the n PCSL data streams on which de-skewing is performed, inner-code encoding is performed on data on which first interleaving is performed, and inner-code encoded data is output. In addition, the transmitter processing module may further determine, based on a status of performing outer-code decoding on the data, quality of a link for transmission of data to the transmitter processing module. A value of n may be 8, 16, 32, 64, or the like, and a value of m may be 4, 8, 16, 32, or the like.

Similarly, the link monitoring method may further be applied to another receiver processing module provided in embodiments of this application. After receiving data, the receiver processing module performs de-interleaving on the data, to obtain n PCSL data streams. On one hand, the receiver processing module outputs the n PCSL data streams by using a PMA sublayer. On the other hand, the receiver processing module also performs outer-code decoding on the n PCSL data streams, and determines quality of a link based on a status of the outer-code decoding.

It should be noted that the foregoing descriptions of the application scenarios of the link monitoring method provided in embodiments of this application is described by using some implementations of the transmitter processing module and some implementations of the receiver processing module as examples. However, it is not excluded that the application scenarios of the link monitoring method provided in embodiments of this application can also be applied to processing modules of other structures provided in embodiments of this application. Details are not described herein again.

It should be noted that, a sequence of the steps of the link monitoring method provided in embodiments of this application may be appropriately adjusted, and a step may be added or removed based on a situation. Any variation method readily figured out by a person skilled in the art within the technical scope disclosed in this application shall fall within the protection scope of this application. Therefore, details are not described herein.

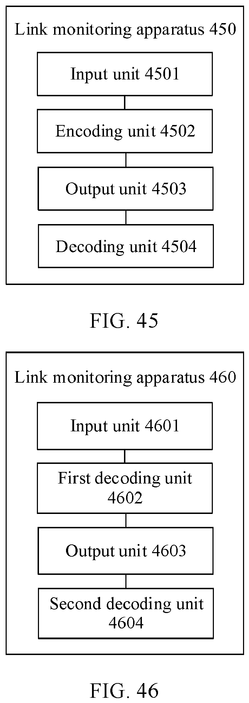

An embodiment of this application further provides a link monitoring apparatus. As shown in FIG. 45, a link monitoring apparatus 450 includes:
an input unit 4501, configured to receive outer-code encoded data;
an encoding unit 4502, configured to perform inner-code encoding on the outer-code encoded data;
an output unit 4503, configured to output inner-code encoded data; and
a decoding unit 4504, configured to perform outer-code decoding on the outer-code encoded data.

The decoding unit 4504 is further configured to determine, based on a status of performing outer-code decoding on the outer-code encoded data, quality of a link for transmission of the outer-code encoded data.

Optionally, the decoding unit 4504 is specifically configured to: determine a quantity of erroneous symbols in each of P1 codeword sequences based on a status of performing outer-code decoding on the P1 codeword sequences of the outer-code encoded data, where P1 is a positive integer; and determine the quality of the link based on a quantity of erroneous symbols in the P1 codeword sequences.

Optionally, the decoding unit 4504 is specifically configured to: determine, based on a status of performing outer-code decoding on a codeword sequence of the outer-code encoded data, an indication parameter corresponding to the codeword sequence; and determine the quality of the link based on indication parameters corresponding to P2 codeword sequences of the outer-code encoded data, where P2 is a positive integer.

Optionally, outer-code decoded data is data on which outer-code encoding and de-skewing are performed.

Optionally, the outer-code decoded data is data on which outer-code encoding, lane reordering, and first de-interleaving are performed.

Optionally, the outer-code decoded data is data on which outer-code encoding and data extraction are performed.

Optionally, the inner-code encoded data is data on which outer-code encoding is performed.

Optionally, the inner-code encoded data is data on which outer-code encoding and de-skewing are performed.

Optionally, the inner-code encoded data is data on which outer-code encoding, de-skewing, and lane reordering are performed.

Optionally, the inner-code encoded data is data on which outer-code encoding, de-skewing, lane reordering, and first de-interleaving are performed.

Optionally, the inner-code encoded data is data on which outer-code encoding and data processing are performed, and the data processing includes first interleaving.

In conclusion, in the link monitoring apparatus, the outer-code encoded data is received, inner-code encoding is performed on the outer-code encoded data, and the inner-code encoded data is output. In addition, outer-code decoding is performed on the outer-code encoded data, and the quality of the link for transmission of the outer-code encoded data is determined based on the status of performing outer-code decoding on the outer-code encoded data. This can effectively monitor the quality of the link.

In addition, in the link monitoring apparatus, inner-code encoding needs to be performed on the outer-code encoded data, and the inner-code encoded data is output. In addition, outer-code decoding is performed on the outer-code encoded data, and the quality of the link is determined based on the status of the outer-code decoding. The two processes are separately performed. Therefore, the process of performing outer-code decoding on the data and determining the quality of the link does not affect the process of performing inner-code encoding on the data and outputting the data, and does not additionally increase an overall transmission delay of data. Therefore, the link monitoring apparatus can be applied to more transmission scenarios, and in particular, to a transmission scenario that has a low requirement on a transmission delay.

An embodiment of this application further provides a link monitoring apparatus. As shown in FIG. 46, a link monitoring apparatus 460 includes:
an input unit 4601, configured to receive outer-code encoded and inner-code encoded data;
a first decoding unit 4602, configured to perform inner-code decoding on the outer-code encoded and inner-code encoded data;
an output unit 4603, configured to output inner-code decoded data; and
a second decoding unit 4604, configured to perform outer-code decoding on the inner-code decoded data.

The second decoding unit 4604 is further configured to determine, based on a status of performing outer-code decoding on the inner-code decoded data, quality of a link for transmission of the outer-code encoded and inner-code encoded data.

Optionally, the second decoding unit 4604 is specifically configured to: determine a quantity of erroneous symbols in each of P3 codeword sequences based on a status of performing outer-code decoding on the P3 codeword sequences of the inner-code decoded data, where P3 is a positive integer; and determine the quality of the link based on a quantity of erroneous symbols in the P3 codeword sequences.

Optionally, the second decoding unit 4604 is specifically configured to: determine, based on a status of performing outer-code decoding on the codeword sequence of the inner-code decoded data, an indication parameter corresponding to a codeword sequence; and determine the quality of the link based on indication parameters corresponding to P4 codeword sequences of the inner-code decoded data, where P4 is a positive integer.

Optionally, outer-code decoded data is data on which inner-code decoding and de-skewing are performed.

Optionally, the outer-code decoded data is data on which inner-code decoding and first de-interleaving are performed.

Optionally, the outer-code decoded data is data on which inner-code decoding, lane reordering, and first de-interleaving are performed.

Optionally, the outer-code decoded data is data on which inner-code decoding and data extraction are performed.

Optionally, the inner-code decoded data is data on which data processing is performed, the outer-code decoded data is data on which inner-code decoding and inverse processing of the data processing are performed, the data processing includes first interleaving, and the inverse processing includes second de-interleaving.

Optionally, the output data is data on which inner-code decoding is performed.

Optionally, the inner-code decoded data is the data on which data processing is performed, the output data is data on which inner-code decoding and inverse processing of the data processing are performed, the data processing includes first interleaving, and the inverse processing includes second de-interleaving.

In conclusion, in the link monitoring apparatus provided in this embodiment of this application, the outer-code encoded and inner-code encoded data is received, inner-code decoding is performed on the outer-code encoded and inner-code encoded data, and the inner-code decoded data is output. In addition, outer-code decoding is performed on the inner-code decoded data, and the quality of the link for transmission of the outer-code encoded and inner-code encoded data is determined based on a status of performing outer-code decoding on the inner-code decoded data. This can effectively monitor the quality of the link.

In addition, in the link monitoring apparatus, the inner-code decoded data needs to be output. In addition, outer-code decoding needs to be performed on the inner-code decoded data, and the quality of the link is determined based on the status of the outer-code decoding. The two processes are separately performed. Therefore, the process of performing outer-code decoding on the data and determining the quality of the link does not affect the process of outputting the inner-code decoded data, and does not additionally increase an overall transmission delay of data. Therefore, the link monitoring apparatus can be applied to more transmission scenarios, and in particular, to a transmission scenario that has a low requirement on a transmission delay.

A person skilled in the art may clearly understand that, for the purpose of convenient and brief description, for a detailed working process of the foregoing apparatus and unit, refer to corresponding content in the method embodiments. Details are not described herein again.

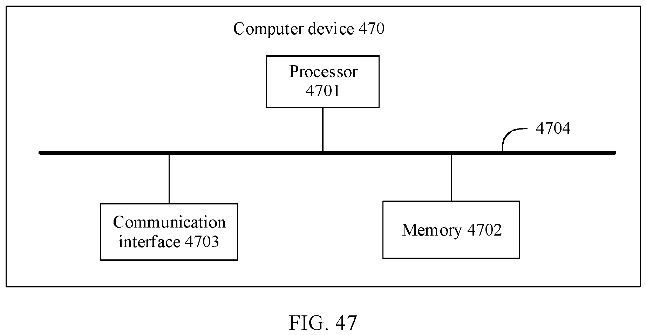

An embodiment of this application provides a computer device. FIG. 47 is an example of a diagram of a possible architecture of a computer device. As shown in FIG. 47, a computer device 470 may include a processor 4701, a memory 4702, a communication interface 4703, and a bus 4704. In the computer device, there may be one or more processors 4701. FIG. 47 shows only one of the processors 4701. Optionally, the processor 4701 may be a central processing unit (central processing unit, CPU). If the computer device includes a plurality of processors 4701, the plurality of processors 4701 may be of a same type or different types. Optionally, the plurality of processors of the computer device may be integrated into a multi-core processor.

The memory 4702 stores computer instructions and data, and the memory 4702 may store computer instructions and data required to implement the method provided in this application. The memory 4702 may be any one or any combination of the following storage media: a nonvolatile memory (for example, a read-only memory (read-only memory, ROM), a solid-state disk (solid-state disk, SSD), a hard disk drive (hard disk drive, HDD), or an optical disc) or a volatile memory.

The communication interface 4703 may be any one or any combination of the following components with a network access function: a network interface (for example, an Ethernet interface) and a wireless network interface card.

The communication interface 4703 is used by the computer device to perform data communication with another node or another computer device.

FIG. 47 further draws the bus 4704 as an example. The processor 4701, the memory 4702, and the communication interface 4703 may be connected by using the bus 4704. In this way, the processor 4701 may access the memory 4702 by using the bus 4704, and may further exchange data with another node or another computer device through the communication interface 4703.

In this application, the computer device executes the computer instructions in the memory 4702, to implement the method provided in this application. For example, outer-code encoded data is received, inner-code encoding is performed on the outer-code encoded data, and inner-code encoded data is output. Outer-code decoding is performed on the outer-code encoded data, and quality of a link for transmission of the outer-code encoded data is determined based on a status of performing outer-code decoding on the outer-code encoded data. In addition, for an implementation process in which the computer device executes the computer instructions in the memory 4702, to perform steps of the method provided in this application, refer to corresponding descriptions in the foregoing method embodiments.

An embodiment of this application further provides a computer-readable storage medium. The computer-readable storage medium is a non-volatile computer-readable storage medium, and includes program instructions. When the program instructions are run on a computer device, the computer device is enabled to perform the method provided in embodiments of this application.

An embodiment of this application further provides a computer program product including instructions. When the computer program product is run on a computer, the computer is enabled to perform the method provided in embodiments of this application.

A person of ordinary skill in the art may understand that all or some of the steps of the embodiments may be implemented by hardware or a program instructing related hardware. The program may be stored in a computer-readable storage medium. The storage medium may be a read-only memory, a magnetic disk, an optical disc, or the like.

In embodiments of this application, the terms "first", "second", and "third" are merely used for description, but cannot be understood as an indication or implication of relative importance. The term "at least one" means one or more, and the term "a plurality of" means two or more, unless otherwise expressly limited.

The term "and/or" in this application describes only an association relationship for describing associated objects and represents that three relationships may exist. For example, A and/or B may represent the following three cases: Only A exists, both A and B exist, and only B exists. In addition, the character "/" in this specification usually indicates an "or" relationship between the associated objects.

The foregoing descriptions are only optional embodiments of this application, but are not intended to limit this application. Any modification, equivalent replacement, or improvement made within the concept and principle of this application should fall within the protection scope of this application.

## Claims

1. A link monitoring method, wherein the method comprises:
receiving outer-code encoded data;
performing inner-code encoding on the outer-code encoded data, and outputting inner-code encoded data;
performing outer-code decoding on the outer-code encoded data; and
determining, based on a status of performing outer-code decoding on the outer-code encoded data, quality of a link for transmission of the outer-code encoded data.

2. The method according to claim 1, wherein the determining, based on a status of performing outer-code decoding on the outer-code encoded data, quality of a link for transmission of the outer-code encoded data comprises:
determining a quantity of erroneous symbols in each of P1 codeword sequences based on a status of performing outer-code decoding on the P1 codeword sequences of the outer-code encoded data, wherein P1 is a positive integer; and
determining the quality of the link based on a quantity of erroneous symbols in the P1 codeword sequences.

3. The method according to claim 1, wherein the determining, based on a status of performing outer-code decoding on the outer-code encoded data, quality of a link for transmission of the outer-code encoded data comprises:
determining, based on a status of performing outer-code decoding on a codeword sequence of the outer-code encoded data, an indication parameter corresponding to the codeword sequence; and
determining the quality of the link based on indication parameters corresponding to P2 codeword sequences of the outer-code encoded data, wherein P2 is a positive integer.

4. The method according to any one of claims 1 to 3, wherein outer-code decoded data is data on which outer-code encoding and de-skewing are performed.

5. The method according to any one of claims 1 to 4, wherein the outer-code decoded data is data on which outer-code encoding, lane reordering, and first de-interleaving are performed.

6. The method according to any one of claims 1 to 5, wherein the outer-code decoded data is data on which outer-code encoding and data extraction are performed.

7. The method according to any one of claims 1 to 6, wherein the inner-code encoded data is data on which outer-code encoding is performed.

8. The method according to any one of claims 1 to 6, wherein the inner-code encoded data is data on which outer-code encoding and de-skewing are performed.

9. The method according to any one of claims 1 to 6, wherein the inner-code encoded data is data on which outer-code encoding, de-skewing, and lane reordering are performed.

10. The method according to any one of claims 1 to 6, wherein the inner-code encoded data is data on which outer-code encoding, de-skewing, lane reordering, and first de-interleaving are performed.

11. The method according to any one of claims 1 to 10, wherein the inner-code encoded data is data on which outer-code encoding and data processing are performed, and the data processing comprises first interleaving.

12. A link monitoring method, wherein the method comprises:
receiving outer-code encoded and inner-code encoded data;
performing inner-code decoding on the outer-code encoded and inner-code encoded data, and outputting inner-code decoded data;
performing outer-code decoding on the inner-code decoded data; and
determining, based on a status of performing outer-code decoding on the inner-code decoded data, quality of a link for transmission of the outer-code encoded and inner-code encoded data.

13. The method according to claim 12, wherein the determining, based on a status of performing outer-code decoding on the inner-code decoded data, quality of a link for transmission of the outer-code encoded and inner-code encoded data comprises:
determining a quantity of erroneous symbols in each of P3 codeword sequences based on a status of performing outer-code decoding on the P3 codeword sequences of the inner-code decoded data, wherein P3 is a positive integer; and
determining the quality of the link based on a quantity of erroneous symbols in the P3 codeword sequences.

14. The method according to claim 12, wherein the determining, based on a status of performing outer-code decoding on the inner-code decoded data, quality of a link for transmission of the outer-code encoded and inner-code encoded data comprises:
determining, based on a status of performing outer-code decoding on a codeword sequence of the inner-code decoded data, an indication parameter corresponding to the codeword sequence; and
determining the quality of the link based on indication parameters corresponding to P4 codeword sequences of the inner-code decoded data, wherein P4 is a positive integer.

15. The method according to any one of claims 12 to 14, wherein outer-code decoded data is data on which inner-code decoding and de-skewing are performed.

16. The method according to any one of claims 12 to 15, wherein the outer-code decoded data is data on which inner-code decoding and first de-interleaving are performed.

17. The method according to any one of claims 12 to 16, wherein the outer-code decoded data is data on which inner-code decoding, lane reordering, and first de-interleaving are performed.

18. The method according to any one of claims 12 to 17, wherein the outer-code decoded data is data on which inner-code decoding and data extraction are performed.

19. The method according to any one of claims 12 to 18, wherein the inner-code decoded data is data on which data processing is performed, the outer-code decoded data is data on which inner-code decoding and inverse processing of the data processing are performed, the data processing comprises first interleaving, and the inverse processing comprises second de-interleaving.

20. The method according to any one of claims 12 to 19, wherein the output data is data on which inner-code decoding is performed.

21. The method according to any one of claims 12 to 19, wherein the inner-code decoded data is the data on which data processing is performed, the output data is the data on which inner-code decoding and inverse processing of the data processing are performed, the data processing comprises first interleaving, and the inverse processing comprises second de-interleaving.

22. A link monitoring apparatus, wherein the apparatus comprises:
an input unit, configured to receive outer-code encoded data;
an encoding unit, configured to perform inner-code encoding on the outer-code encoded data; and
an output unit, configured to output inner-code encoded data; and
a decoding unit, configured to perform outer-code decoding on the outer-code encoded data, wherein
the decoding unit is further configured to determine, based on a status of performing outer-code decoding on the outer-code encoded data, quality of a link for transmission of the outer-code encoded data.

23. The apparatus according to claim 22, wherein the decoding unit is specifically configured to:
determine a quantity of erroneous symbols in each of P1 codeword sequences based on a status of performing outer-code decoding on the P1 codeword sequences of the outer-code encoded data, wherein P1 is a positive integer; and
determine the quality of the link based on a quantity of erroneous symbols in the P1 codeword sequences.

24. The apparatus according to claim 22, wherein the decoding unit is specifically configured to:
determine, based on a status of performing outer-code decoding on a codeword sequence of the outer-code encoded data, an indication parameter corresponding to the codeword sequence; and
determine the quality of the link based on indication parameters corresponding to P2 codeword sequences of the outer-code encoded data, wherein P2 is a positive integer.

25. The apparatus according to any one of claims 22 to 24, wherein outer-code decoded data is data on which outer-code encoding and de-skewing are performed.

26. The apparatus according to any one of claims 22 to 25, wherein the outer-code decoded data is data on which outer-code encoding, lane reordering, and first de-interleaving are performed.

27. The apparatus according to any one of claims 22 to 26, wherein the outer-code decoded data is data on which outer-code encoding and data extraction are performed.

28. The apparatus according to any one of claims 22 to 27, wherein the inner-code encoded data is data on which outer-code encoding is performed.

29. The apparatus according to any one of claims 22 to 27, wherein the inner-code encoded data is data on which outer-code encoding and de-skewing are performed.

30. The apparatus according to any one of claims 22 to 27, wherein the inner-code encoded data is data on which outer-code encoding, de-skewing, and lane reordering are performed.

31. The apparatus according to any one of claims 22 to 27, wherein the inner-code encoded data is data on which outer-code encoding, de-skewing, lane reordering, and first de-interleaving are performed.

32. The apparatus according to any one of claims 22 to 31, wherein the inner-code encoded data is data on which outer-code encoding and data processing are performed, and the data processing comprises first interleaving.

33. A link monitoring apparatus, wherein the apparatus comprises:
an input unit, configured to receive outer-code encoded and inner-code encoded data;
a first decoding unit, configured to perform inner-code decoding on the outer-code encoded and inner-code encoded data;
an output unit, configured to output inner-code decoded data; and
a second decoding unit, configured to perform outer-code decoding on the inner-code decoded data, wherein
the second decoding unit is further configured to determine, based on a status of performing outer-code decoding on the inner-code decoded data, quality of a link for transmission of the outer-code encoded and inner-code encoded data.

34. The apparatus according to claim 33, wherein the second decoding unit is specifically configured to:
determine a quantity of erroneous symbols in each of P3 codeword sequences based on a status of performing outer-code decoding on the P3 codeword sequences of the inner-code decoded data, wherein P3 is a positive integer; and
determine the quality of the link based on a quantity of erroneous symbols in the P3 codeword sequences.

35. The apparatus according to claim 33, wherein the second decoding unit is specifically configured to:
determine, based on a status of performing outer-code decoding on a codeword sequence of the inner-code decoded data, an indication parameter corresponding to the codeword sequence; and
determine the quality of the link based on indication parameters corresponding to P4 codeword sequences of the inner-code decoded data, wherein P4 is a positive integer.

36. The apparatus according to any one of claims 33 to 35, wherein outer-code decoded data is data on which inner-code decoding and de-skewing are performed.

37. The apparatus according to any one of claims 33 to 36, wherein the outer-code decoded data is data on which inner-code decoding and first de-interleaving are performed.

38. The apparatus according to any one of claims 33 to 37, wherein the outer-code decoded data is data on which inner-code decoding, lane reordering, and first de-interleaving are performed.

39. The apparatus according to any one of claims 33 to 38, wherein the outer-code decoded data is data on which inner-code decoding and data extraction are performed.

40. The apparatus according to any one of claims 33 to 39, wherein the inner-code decoded data is data on which data processing is performed, the outer-code decoded data is data on which inner-code decoding and inverse processing of the data processing are performed, the data processing comprises first interleaving, and the inverse processing comprises second de-interleaving.

41. The apparatus according to any one of claims 33 to 40, wherein the output data is data on which inner-code decoding is performed.

42. The apparatus according to any one of claims 33 to 40, wherein the inner-code decoded data is the data on which data processing is performed, the output data is the data on which inner-code decoding and inverse processing of the data processing are performed, the data processing comprises first interleaving, and the inverse processing comprises second de-interleaving.

43. A computer device, comprising a memory and a processor, wherein the memory stores program instructions, and the processor runs the program instructions, to perform the method according to any one of claims 1 to 21.

44. A computer-readable storage medium, comprising program instructions, wherein when the program instructions are run on a computer device, the computer device is enabled to perform the method according to any one of claims 1 to 21.

45. A computer program product, wherein when the computer program product runs on a computer, the computer is enabled to perform the method according to any one of claims 1 to 21.
